# EUROPÄISCHE PATENTSCHRIFT

(11) **EP 4 040 191 B1**
(45) Veröffentlichungstag und Bekanntmachung des Hinweises auf die Patenterteilung: **14.10.2026**
(21) Anmeldenummer: 22162650.0
(22) Anmeldetag: 19.02.2021
(51) Int. Cl.: H03B 5/32, G01S 7/40, G01S 7/03, G01S 13/34, H03L 7/16

(54) **RADARSYSTEM UND SYNCHRONISATIONSVERFAHREN**
RADAR SYSTEM AND SYNCHRONISATION METHOD
SYSTÈME RADAR ET PROCÉDÉ DE SYNCHRONISATION

(30) Priorität: 20.02.2020 EP 20158599; 24.08.2020 EP 20192395
(43) Veröffentlichungstag der Anmeldung: 10.08.2022
(62) Dokumentnummer(n) der früheren Anmeldung(en) nach Art. 76 EPÜ: 21705552.4 / 3 903 413
(73) Patentinhaber: 2pi-Labs GmbH, 44801 Bochum (DE)
(72) Erfinder: Jaeschke, Timo, 45525 Hattingen (DE); Kueppers, Simon, 44879 Bochum (DE)
(74) Vertreter: Von Rohr Patentanwälte Partnerschaft mbB

(56) Entgegenhaltungen:
- EP-A2- 2 293 096
- DE-A1- 102018 206 701

## Beschreibung

Die vorliegende Erfindung betrifft grundsätzlich Oszillatoren zur Erzeugung eines elektrischen Wechselsignals. Insbesondere betrifft die vorliegende Erfindung ein Radarsystem mit einer Referenzoszillatoranordnung mit einem Referenzoszillator sowie ein Synchronisationsverfahren.

Oszillatoren im Sinne der vorliegenden Erfindung sind vorzugsweise elektronisch realisierte Vorrichtungen zur Erzeugung eines bevorzugt zumindest im Wesentlichen periodischen und/oder mono-frequenten elektrischen Wechselsignals als Ausgangssignal, insbesondere einer Wechselspannung und/oder eines Wechselstroms.

Referenzoszillatoren im Sinne der vorliegenden Erfindung sind vorzugsweise solche Oszillatoren, die sich durch eine besonders hohe Genauigkeit und/oder Stabilität des Ausgangssignals bzw. dessen Frequenz und/oder Phase auszeichnen, insbesondere auch im Freilauf. Hierzu können Referenzoszillatoren ein Frequenzreferenzelement zur Erzeugung einer kurz- und/oder langzeitstabilen Schwingung des Referenzoszillators aufweisen. Bei einem Frequenzreferenzelement handelt es sich vorzugsweise um eine Einrichtung zur Erzeugung eines Schwingkreises hoher elektrischer Güte, eines Schwingkreises mit geringer Abhängigkeit von äußeren Randbedingungen wie einer Temperatur, und/oder eines Schwingkreises mit einer geringen Änderung von Schwingeigenschaften durch Alterung o.dgl.

Ganz besonders bevorzugt handelt es sich bei Referenzoszillatoren im Sinne der vorliegenden Erfindung um Quarzoszillatoren, auch quarzstabilisierte Oszillatoren genannt. Quarzoszillatoren weisen einen Schwingquarz (als Frequenzreferenzelement) auf. Der Schwingquarz wird vorzugsweise als frequenzbestimmendes Bauelement eingesetzt, insbesondere zur Bildung eines Schwingkreises des Quarzoszillators mit dem Schwingquarz zur Erzeugung der Schwingfrequenz des Referenzoszillators bzw. der Frequenz seines Ausgangssignals.

Quarzoszillatoren werden regelmäßig mit der Abkürzung XO (für Crystal Oscillator) bezeichnet. Varianten von Quarzoszillatoren, die Referenzoszillatoren im Sinne der vorliegenden Erfindung sein oder einen Teil hiervon bilden können, sind vorzugsweise in ihrer Schwingfrequenz bzw. der Frequenz ihres Ausgangssignals abstimmbare Quarzoszillatoren (VXO - Variable Crystal Oscillator), durch eine elektrische Spannung abstimmbare Quarzoszillatoren (VCXO - Voltage Controlled Crystal Oscillator), temperaturkompensierte (gegen Temperaturdrift der Schwingfrequenz bzw. der Frequenz ihres Ausgangssignals stabilisierte) Quarzoszillatoren (TCXO - Temperature Compensated Crystal Oscillator), temperaturkompensierte abstimmbare Quarzoszillatoren (TCCXO - Temperature Compensated Controlled Crystal Oscillator), temperaturkompensierte spannungsgesteuerte Quarzoszillatoren (TCVCXO - Temperature Compensated Voltage Controlled Crystal Oscillator) sowie sonstige, durch einen Schwingquarz stabilisierte Oszillatoren.

Grundsätzlich zählen im Sinne der vorliegenden Erfindung vorzugsweise auch sogenannte Ofenquarzoszillatoren (OCXO - Oven Controlled Crystal Oscillator) zu den Referenzoszillatoren, insbesondere abstimmbare Ofenquarzoszillatoren (OCVCXO - Oven Controlled Voltage Controlled Crystal Oscillator). Diese sind dadurch temperaturkompensiert, dass sie mittels einer Heizung auf eine bestimmte, vorgegebene Arbeitstemperatur geregelt werden.

Aufgrund der aufwendigen Konstruktion, dem damit einhergehenden Herstellungsaufwand und hohen Materialeinsatz sowie der durch die Heizung hervorgerufenen hohen Stromaufnahme von Ofenquarzoszillatoren ist es jedoch bevorzugt, dass Referenzoszillatoren im Sinne der vorliegenden Erfindung keine Ofenquarzoszillatoren sind oder aufweisen bzw. heizungslos realisiert sind.

Grundsätzlich betrifft die vorliegende Erfindung eine Referenzoszillatoranordnung, wie sie zur Erzeugung eines Ausgangssignals als Takt verwendet wird. Ganz besonders bevorzugt ist eine Referenzoszillatoranordnung zur Erzeugung eines Takts für Hochfrequenz-Systeme, insbesondere im Millimeterwellenbereich bzw. zwischen 30 GHz und 1 THz, geeignet. Grundsätzlich können jedoch auch andere Frequenzen und Ausgangsignale für andere Anwendungen als für die Nutzung als Takt erzeugt werden oder erzeugbar sein. Eine Frequenz des Ausgangssignals der Referenzoszillatoranordnung kann eine vom letztendlichen Takt abweichende Frequenz aufweisen, aus der der Takt abgeleitet wird oder werden kann.

Die US 10,491,225 B2 betrifft eine Referenzoszillatoranordnung, bei der ein Referenzoszillator das Eingangssignal eines Phasenregelkreises (PLL - Phase Locked Loop) bildet, der wiederum einen spannungsgesteuerten Oszillator mit dem Referenzoszillator synchronisiert.

Bei dem spannungsgesteuerten Oszillator (VCO - Voltage Controlled Oscillator) handelt es sich um einen klassischen, quarzfreien Oszillator basierend auf einer elektrischen Schaltung, die über eine Steuerspannung die Veränderung der Oszillationsfrequenz erlaubt.

Der Phasenregelkreis ist dazu eingerichtet, das Ausgangssignal des spannungsgesteuerten Oszillators, vorliegend das durch einen Faktor N geteilte Ausgangssignal, mit dem Referenzoszillatorsignal abzugleichen und auf diese Weise die Steuerspannung des spannungsgesteuerten Oszillators zu regeln. Der Phasenregelkreis ist daher ein Regelkreis zur Regelung des spannungsgesteuerten Oszillators. Die Rückkopplung des durch den Faktor N geteilten Ausgangssignals des spannungsgesteuerten Oszillators zum Eingang des Phasenregelkreises führt zur Bildung einer Ausgangsfrequenz des spannungsgesteuerten Oszillators, die dem N-fachen der Ausgangsfrequenz des Referenzoszillatorsignals entspricht.

Der Phasenregelkreis prägt innerhalb seiner Schleifenbandbreite dem spannungsgesteuerten Oszillator die Charakteristik des Referenzoszillators auf, sodass die Regelung des spannungsgesteuerten Oszillators durch den Phasenregelkreis auf Basis des Ausgangssignals des Referenzoszillators die Eigenschaften des spannungsgesteuerten Oszillators verbessert bzw. diesen stabilisiert.

Die US 9,281,822 B2 betrifft eine Referenzoszillatoranordnung in Form eines Ofenquarzoszillators, der zur Kompensation einer von dem Ofenquarzoszillator in der Aufheizphase bewirkten Drift ausgebildet ist. Hierzu weist der Ofenquarzoszillator einen spannungsgesteuerten Quarzoszillator auf, der über einen Phasenregelkreis gesteuert temperaturkompensiert wird, also einen temperaturkompensierten Quarzoszillator bildet. Diese Funktion wird verwendet, um ein gegen Temperaturdrift kompensiertes Ausgangssignal bereitzustellen, bis eine Heizeinrichtung die Anordnung auf ihre Nenn-Temperatur gebracht hat und diese fortan als klassischer Ofenquarzoszillator arbeitet. Abgesehen von der früheren Verfügbarkeit eines Ausgangssignals führt diese Lösung weiterhin zu einer hohen Stromaufnahme und einem hohen Materialeinsatz.

Die DE 10 2018 206 701 A1 betrifft ein Verfahren zum Überwachen eines FMCW-Sensors sowie einen derartigen Sensor mit mehreren lokalen Oszillatoren. In einem Beispiel ist vorgesehen, dass ein erster Hochfrequenzbaustein als Master arbeitet und ein weiterer Hochfrequenzbaustein als Slave arbeitet, wobei zur Synchronisation des zweiten Hochfrequenzbausteins mit dem ersten Hochfrequenzbaustein an einem Synchronisationssignaleingang des zweiten Hochfrequenzbausteins ein Lokaloszillatorsignal des ersten Hochfrequenzbausteins von einem Synchronisationssignalausgang des ersten Hochfrequenzbausteins angelegt wird.

Die EP 2 293 096 A2 betrifft ein Verfahren und eine Vorrichtung zum Bereitstellen eines Reflexionssignals, wobei ein erstes Referenzsignal u.a. durch Mischen der zwei Ausgangssignale von zwei Frequenzgeneratoren erzeugt wird und wobei das erste Referenzsignal zur Demodulation eines Empfangssignals und zur Generierung des Abtasttaktes oder zur Erzeugung eines zweiten Referenzsignals zur weiteren Demodulation des Empfangssignals dient.

Aufgabe der vorliegenden Erfindung ist es vor diesem Hintergrund ein Radarsystem oder ein Synchronisationsverfahren anzugeben, bei denen Referenzoszillatoren synchrone Ausgangssignale bereitstellen können, insbesondere mit hoher Frequenzstabilität und/oder geringem Phasenrauschen und/oder mit hoher Zuverlässigkeit.

Die vorliegende Aufgabe wird durch ein Radarsystem gemäß Anspruch 1 oder ein Synchronisationsverfahren gemäß Anspruch 13 gelöst. Vorteilhafte Weiterbildungen sind Gegenstand der Unteransprüche.

Ein Teil der Erfindung betrifft eine Referenzoszillatoranordnung, die einen ersten Referenzoszillator zur Erzeugung eines ersten Ausgangsignals und einen bevorzugt vom ersten abweichenden zweiten Referenzoszillator zur Erzeugung eines zweiten Ausgangssignals aufweist.

Darüber hinaus weist die Referenzoszillatoranordnung einen Phasenregelkreis zur Regelung der Frequenz und/oder Phase des zweiten Referenzoszillators auf die Frequenz und/oder Phase des ersten Referenzoszillators auf. Mit anderen Worten regelt der Phasenregelkreis die Frequenz des zweiten Referenzoszillators auf die Frequenz des ersten Referenzoszillators Frequenz und/oder die Phase des zweiten Referenzoszillators auf die Phase des ersten Referenzoszillators oder ist hierzu ausgebildet.

Mit anderen Worten weist die Referenzoszillatoranordnung einen Phasenregelkreis auf, der auf Basis des ersten Ausgangssignals des ersten Referenzoszillators den bevorzugt vom ersten unterschiedlichen zweiten Referenzoszillator regelt, sodass der zweite Referenzoszillator das zweite Ausgangssignal erzeugt, das im Ergebnis über die Regelung mittels des Phasenregelkreises teilweise von den Eigenschaften des ersten Referenzoszillators (mit-) geprägt ist.

Üblicherweise wird in einem Phasenregelkreis kein Referenzoszillator eingesetzt, da das Ausgangssignal des durch den Phasenregelkreis geregelten Oszillators durch die Regelung von einem mit einem Referenzeingang des Phasenregelkreises gekoppelten Referenzoszillator geprägt wird, sodass der Einsatz eines weiteren Referenzoszillators im Phasenregelkreis nicht lohnenswert scheint.

Es hat sich jedoch in überraschender Weise gezeigt, dass die Disziplinierung des zweiten Referenzoszillators mittels des Phasenregelkreises auf den ersten Referenzoszillator dazu führt, dass positive Eigenschaften beider Referenzoszillatoren vereint werden können, sodass diese Kombination in Hinblick auf die Stabilität der Frequenz, einen geringen Jitter und/oder ein geringes Phasenrauschen einen Ofenquarzoszillator ersetzen kann. Gleichzeitig steht das zweite Ausgangssignal im Vergleich zu einem Ausgangssignal eines Ofenquarzoszillators wesentlich früher in ausreichender Stabilität bereit, da die langwierige Aufheizphase des Ofenquarzes entfällt, und der Materialeinsatz sowie die Stromaufnahme sind im Vergleich geringer.

Der erste Referenzoszillator weist im Freilauf eine bessere Frequenzstabilität als der zweite Referenzoszillator auf. Zusätzlich weist der zweite Referenzoszillator im Freilauf ein geringeres (trägerfernes) Phasenrauschen als der erste Referenzoszillator auf.

Bevorzugt ist zumindest der zweite Referenzoszillator steuerbar, insbesondere ein spannungsgesteuerter Referenzoszillator (VCXO). Hierdurch kann dieser mit einer Steuergröße des Phasenregelkreises geregelt und insbesondere auf den ersten Referenzoszillator diszipliniert werden.

Aufgrund der Synchronisation zweier bevorzugt unterschiedlicher Referenzoszillatoren wird es durch die vorschlagsgemäße Referenzoszillatoranordnung vorzugsweise ermöglicht, (vorteilhafte) Eigenschaften beider Referenzoszillatoren zu kombinieren, insbesondere indem eine (vorteilhafte) Eigenschaft wie eine (bessere) Frequenzstabilität des ersten Referenzoszillators dem zweiten Referenzoszillator aufgeprägt wird, während der zweite Referenzoszillator Stärken in anderen Charakteristika, wie ein im Vergleich zu dem ersten Referenzoszillator geringeres - insbesondere trägerfernes - Phasenrauschen zumindest im Wesentlichen behält.

In einem ersten Aspekt betrifft die vorliegende Erfindung ein Radarsystem mit mehreren Referenzoszillatoranordnungen, von denen mindestens eine Referenzoszillatoranordnung den zuvor beschriebenen Merkmalen genügt. Weiter weist das vorschlagsgemäße Radarsystem eine Taktsynchronisationseinrichtung zur Synchronisation von Takten der Referenzoszillatoranordnungen auf. Hierdurch können die Referenzoszillatoranordnungen des Radarsystems miteinander synchronisierte Ausgangssignale bereitstellen, insbesondere frequenzsynchrone und/oder phasensynchrone Ausgangssignale.

Die Referenzoszillatoranordnungen des Radarsystems können Radarmodule, Radarsender und/oder Radarempfänger bzw. einen Teil dieser bilden. Insbesondere können die Referenzoszillatoranordnungen zum Betrieb unterschiedlicher Radarempfänger vorgesehen sein, die an unterschiedlichen Orten angeordnet sein oder werden können.

Auf Basis desselben Sendesignals können dann mit den Radarempfängern an den unterschiedlichen Orten Empfangssignale auf Basis einer Reflexion desselben Sendesignals empfangen werden, wobei durch Abweichen der Empfangssignale voneinander zusätzliche Informationen aufgrund der räumlichen Verteilung der Radarempfänger ermittelt werden können.

Hierbei ist es nicht erforderlich, wenn auch möglich, dass mehrere den jeweiligen Referenzoszillatoranordnungen zugeordnete Sender zum Aussenden von Radarsignalen verwendet werden. Denn die Synchronisation der Referenzoszillatoranordnungen ermöglicht eine Auswertung von Empfangssignalen auch in dem Fall, in dem ein Empfangssignal nicht auf einem Sendesignal desselben Radarmoduls basiert.

Ein weiterer, auch unabhängig realisierbarer Aspekt der vorliegenden Erfindung betrifft ein Synchronisationsverfahren für Radarsysteme, bei dem mehrere Referenzoszillatoranordnungen miteinander synchronisiert werden.

Die Referenzoszillatoranordnungen weisen hierbei jeweils einen ersten Referenzoszillator und einen zweiten Referenzoszillator auf. Die Frequenz und/oder Phase des zweiten Referenzoszillators kann mit einem Phasenregelkreis auf die Frequenz und/oder Phase des ersten Referenzoszillators geregelt werden. Hierdurch kann der zweite Referenzoszillator auf den ersten Referenzoszillator diszipliniert werden. Insbesondere kann der zweite Referenzoszillator (trägernah) auf die Frequenz und/oder Phase des ersten Referenzoszillators geregelt werden.

Weiter ist vorgesehen, dass die Frequenz und/oder Phase des ersten Referenzoszillators auf Basis eines Kalibriersignals, insbesondere auf dessen Frequenz und/oder Phase, kalibriert wird.

Beispielsweise kann durch Verwendung eines Satellitennavigationssignals, Funk-Zeitsignals und/oder eines Netzwerksynchronisationssignals als Kalibriersignal oder zur Bildung des Kalibriersignals die Kalibrierung der Frequenz und/oder Phase des ersten Referenzoszillators ermöglicht werden.

Die Kalibrierung des ersten Referenzoszillators ermöglicht es im Folgenden, insbesondere aufgrund der Regelung des zweiten Referenzoszillators über den Phasenregelkreis auf die Frequenz und/oder Phase des ersten Referenzoszillators, ein frequenz- und/oder phasensynchrones zweites Ausgangsignal durch an unterschiedlichen Orten vorgesehene oder anordenbare Referenzoszillatoranordnungen bzw. Radarmodule und/oder Radarempfänger zu erzeugen.

Alternativ oder zusätzlich kann die Frequenz und/oder Phase des zweite Referenzoszillator (dauerhaft) auf die Phase und/oder Frequenz eines Kalibriersignals bzw. einer (externen) Kalibriersignalquelle geregelt werden und/oder kann der zweite Referenzoszillator bzw. Phasenregelkreis (dauerhaft) mit dem Kalibriersignal gespeist werden. Hierbei wird der erste Referenzoszillator vorzugsweise nicht verwendet. Vorzugsweise wird hierdurch ermöglicht, mehrere Referenzoszillatoranordnungen bzw. Systeme damit, vorzugsweise als Verbund, phasenstarr zusammen bzw. zueinander zu betreiben.

Ein weiterer, auch unabhängig realisierbarer Aspekt der vorliegenden Erfindung betrifft ein Kalibrierverfahren zur Kalibrierung eines ersten Referenzoszillators, wobei die Frequenz und/oder Phase eines zweiten Referenzoszillators mit einem Phasenregelkreis auf die Frequenz und/oder Phase wahlweise des ersten Referenzoszillators oder eines Kalibriersignals geregelt werden kann.

**In** dem Kalibrierverfahren wird der zweite Referenzoszillator durch den Phasenregelkreis so gesteuert, dass dessen Frequenz und/oder Phase abwechselnd zumindest im Wesentlichen mit der Frequenz und/oder Phase des ersten Referenzoszillators und mit der Frequenz und/oder Phase des Kalibriersignals übereinstimmt, wobei eine Steuergröße des Phasenregelkreises bei mit dem Phasenregelkreis gekoppeltem Kalibriersignal ermittelt wird und der ersten Referenzoszillator so abgestimmt wird, dass die Steuergröße bei mit dem Phasenregelkreis gekoppeltem ersten Referenzoszillator zumindest im Wesentlichen der Steuergröße bei mit dem Phasenregelkreis gekoppeltem Kalibriersignal entspricht.

Besonders bevorzugt handelt es sich bei der Steuergröße um eine Steuerspannung bzw. Tuningspannung des zweiten Referenzoszillators, insbesondere zur Regelung und/oder Abstimmung des zweiten Referenzoszillators.

Vorzugsweise wird durch das vorschlagsgemäße Kalibrierverfahren über die Steuergröße mittelbar die Frequenz und/oder Phase des ersten Referenzoszillators auf die des Kalibriersignals kalibriert.

Die Erfindung ermöglicht die Rückführbarkeit der Radar-Entfernungsmessung bzw. der Eigenschaften des zweiten Referenzoszillators auf den ersten Referenzoszillator. Der erste Referenzoszillator fungiert hierbei als Frequenznormal für den zweiten Referenzoszillator.

Der erste Referenzoszillator ist bevorzugt sehr stabil bzw. weist geringe Schwankungen und/oder eine geringe Drift der von ihm erzeugten Schwingung, deren Frequenz, deren Phase, deren (Phasen-)Rauscheigenschaften oder sonstiger, die Qualität der Schwingung bestimmenden Eigenschaften auf, insbesondere in Abhängigkeit von äußeren Bedingungen wie der Temperatur oder einer Alterung.

Die Rückführbarkeit der Radar-Entfernungsmessung auf den ersten Referenzoszillator ermöglicht hierdurch eine hochpräzise Radar-Entfernungsmessung.

Die Erfindung ermöglicht vorzugsweise Intervallkalibrierungen des Systems. Hierbei kann der erste Referenzoszillator mit einem Kalibriersignal als Referenzsignal bzw. externem Frequenznormal synchronisiert werden. Dies erfolgt vorzugsweise nicht dauerhaft, sondern nur phasenweise. Hierbei wird der erste Referenzoszillator in einer ersten Phase eines Intervalls synchronisiert, während er in einer zweiten Phase des Intervalls frei läuft. Bevorzugt schließt sich hieran ein weiteres entsprechendes Intervall an. Auf diese Weise kann der erste Referenzoszillator bzw. das System mit dem Kalibriersignal wiederholt kalibriert werden.

Die Erfindung ermöglicht, dass die Entfernungsmessung (bzw. dessen Jitter und/oder absolute Genauigkeit) mit dem vorschlagsgemäßen Verfahren und/oder System - vorzugsweise durch das FMCW Prinzip und/oder eine bevorzugt synchron resetbare Teilerkette - auf die Stabilität des ersten Referenzoszillators bzw. Referenzquarzregelkreises (also dessen Jitter bzw. korrespondierendes Phasenrauschen und/oder absolute Frequenzgenauigkeit) zurückgeführt wird.

Die Erfindung ermöglich hochpräzise Radar-Messsysteme mit sehr gutem Jitter, der in vorteilhafter Weise im Wesentlichen durch das Phasenrauschen des zweiten Referenzoszillators bestimmt ist, und herausragende absolute Messgenauigkeit, insbesondere durch die Langzeitstabilität und Temperaturkompensation des ersten Referenzoszillators. Durch die Abgleichmöglichkeit des bevorzugt langzeitstabilen ersten Referenzoszillators mit einem Kalibrier- bzw. Referenzsignal, bevorzugt eines externen, hochpräzisen und kalibrierten Frequenznormals, ist die Möglichkeit gegeben, das System vollständig zu kalibrieren und kalibrierte Entfernungsmessungen durchzuführen.

Weitere Aspekte, Vorteile und Eigenschaften der vorliegenden Erfindung ergeben sich aus den Ansprüchen und aus der nachfolgenden Beschreibung bevorzugter Ausführungsbeispiele anhand der Zeichnung.

Es zeigt:
- Fig. 1: eine schematische, blockschaltbildartige Ansicht eines vorschlagsgemäßen Radarmoduls mit einer vorschlagsgemäßen Referenzoszillatoranordnung;
- Fig. 2: Diagramme eines Kalibriersignals und eines ersten Ausgangssignals der vorschlagsgemäßen Referenzoszillatoranordnung über der Zeit;
- Fig. 3A: Diagramm eines Auswahlsignals über der Zeit;
- Fig. 3B: Diagramm einer Steuergröße des zweiten Referenzoszillators über der Zeit;
- Fig. 3C: Diagramm eines Abstimmsignals über der Zeit;
- Fig. 4: Diagramme der Ausgangsleistung des ersten und zweiten Referenzoszillators in dB über der Frequenz; und
- Fig. 5: ein vorschlagsgemäßes Radarsystem mit mehreren Radarmodulen.

In den Figuren werden für gleiche oder ähnliche Teile dieselben Bezugszeichen verwendet, wobei sich entsprechende Eigenschaften und Vorteile ergeben können, auch wenn von einer wiederholten Beschreibung abgesehen wird.

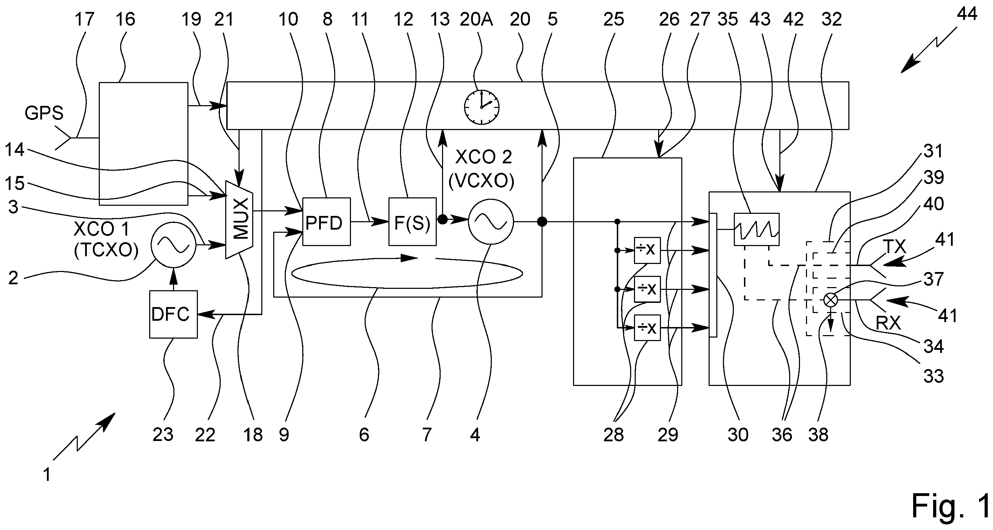

In Fig. 1 ist ein vereinfachtes Blockschaltbild einer vorschlagsgemäßen Referenzoszillatoranordnung 1 dargestellt. Die Referenzoszillatoranordnung 1 weist einen ersten Referenzoszillator 2 auf, der dazu ausgebildet ist, ein erstes Ausgangssignal 3 zu erzeugen. Weiter weist die Referenzoszillatoranordnung 1 einen zweiten Referenzoszillator 4 auf, der dazu ausgebildet ist, ein zweites Ausgangssignals 5 zu erzeugen.

Die Referenzoszillatoranordnung 1 ist vorzugsweise für Radaranwendungen geeignet bzw. ausgebildet. Insbesondere ist das zweites Ausgangssignal 5 dazu geeignet, einen Radarsignalgenerator in die Lage zu versetzen, ein Radarsignal zu erzeugen. Hierzu kann das zweite Ausgangssignal 5 als Referenz oder Referenztakt für einen Oszillator, Teiler und/oder eine Regelschleife zu dienen, wodurch das Radarsignal erzeugt wird oder erzeugbar ist.

Der erste Referenzoszillator 2 und der zweite Referenzoszillator 4 sind vorzugsweise dazu ausgebildet, Ausgangssignale 3, 5 zumindest im Wesentlichen derselben Frequenz zu erzeugen.

Das erste Ausgangssignal 3 und/oder das zweite Ausgangssignal 5 ist/sind vorzugsweise zumindest im Wesentlichen periodisch, bilden (ein) Taktsignal(e), und/oder sind zumindest im Wesentlichen sinusförmige und/oder monofrequente Schwingungen.

Ganz besonders bevorzugt sind sowohl das erste Ausgangssignal 3 als auch das zweite Ausgangssignal 5 zumindest im Wesentlichen monofrequente Sinus-Schwingungen bei zumindest im Wesentlichen derselben Frequenz. Entsprechend sind der erste Referenzoszillator 2 und/oder zweite Referenzoszillator 4 zur Erzeugung dieser Ausgangssignale 3, 5 ausgebildet. Die Ausgangssignale 3, 5 können jedoch auch abweichende Signalformen wie Rechtecksignale sein oder aufweisen.

Bei dem ersten Referenzoszillator 2 handelt es sich vorzugsweise um einen Quarzoszillator, also um einen quarzstabilisierten Referenzoszillator 2, dessen erstes Ausgangssignal 3 durch Einsatz eines Schwingquarzes stabilisiert ist.

Bei dem zweiten Referenzoszillator 4 handelt es sich vorzugsweise um einen Quarzoszillator, also um einen quarzstabilisierten Referenzoszillator 4, dessen zweites Ausgangssignal 5 durch Einsatz eines Schwingquarzes stabilisiert ist.

Der erste Referenzoszillator 2 und der zweite Referenzoszillator 4 sind vorzugsweise unterschiedlich. Insbesondere unterscheiden sie sich in Hinblick auf ihren Aufbau, ihr Schaltungskonzept und/oder ihre Frequenzstabilität, ihre Phasenstabilität und/oder ihr Phasenrauschen (des jeweiligen Ausgangssignals 3, 5 bzw. im Freilauf).

Der erste Referenzoszillator 2 ist vorzugsweise ein temperaturkompensierter Quarzoszillator (TCXO). Hierbei weist der erste Referenzoszillator 2 eine Einrichtung zur Kompensation von Veränderungen der Schwingeigenschaften des ersten Referenzoszillators 2 bzw. der Frequenz und/oder Phase des ersten Ausgangssignals 3 in Abhängigkeit von der Temperatur auf. Insbesondere wird hierdurch eine Temperaturdrift in Abhängigkeit von der Temperatur des Schwingquarzes des ersten Referenzoszillators 2 kompensiert bzw. der erste Referenzoszillator 2 ist dazu ausgebildet.

Die Temperaturkompensation des ersten Referenzoszillators 2 kann mittels einer Temperatur(drift)kompensationseinrichtung erfolgen. Diese kann eine Heizeinrichtung sein oder aufweisen, die den Quarz des ersten Referenzoszillators 2 auf einer konstanten Temperatur hält, wodurch das Schwingverhalten des ersten Referenzoszillators 2 stabilisiert wird oder ist.

Bevorzugt ist hingegen eine heizungsfreie Temperaturkompensation bzw. heizungsfreie Temperatur(drift)kompensationseinrichtung, also eine Kompensation bzw. Temperatur(drift)kompensationseinrichtung, die eine Temperaturabhängigkeit des Verhalten des ersten Referenzoszillators 2 bzw. seines Quarzes ohne Einsatz einer Heizung bzw. ohne aktives Heizen reduziert oder kompensiert.

Die heizungsfreie Temperaturkompensation kann beispielsweise über eine analoge oder digitale, temperaturabhängige Rück- bzw. Gegenkopplung über einen Steuereingang des ersten Referenzoszillators 2 erfolgen, insbesondere mittels eines Controllers, der abhängig von einer Temperatur Steuersignale aus einer Tabelle bestimmt und an den Steuereingang gibt. Alternativ oder zusätzlich kann auch das erste Ausgangssignal 3 auf Basis der Temperatur korrigiert werden.

Der erste Referenzoszillator 2 ist vorzugsweise steuerbar bzw. abstimmbar, insbesondere zwecks Kalibrierung. Der erste Referenzoszillator 2 ist bevorzugt steuerbar bzw. abstimmbar, um eine Frequenz und/oder Phase des ersten Ausgangssignals 3 anpassen zu können. Mit anderen Worten ist der erste Referenzoszillator 2 vorzugsweise abstimmbar, kann also in Bezug auf die Frequenz und/oder Phase des durch den ersten Referenzoszillator 2 erzeugbaren ersten Ausgangssignals 3 gesteuert oder geregelt werden.

Ganz besonders bevorzugt handelt es sich bei dem ersten Referenzoszillator 2 daher im Ergebnis um einen abstimmbaren, temperaturkompensierten Quarzoszillator (TCXO/TCCXO/TCVCXO).

Der zweite Referenzoszillator 4 ist vorzugsweise ein steuerbarer Quarzoszillator (CXO), insbesondere ein spannungsgesteuerter Quarzoszillator (VCXO). Der zweite Referenzoszillator 4 ist vorzugsweise nicht temperaturkompensiert, weist also (im Gegensatz zum ersten Referenzoszillator 2) keine Temperatur(drift)kompensationseinrichtung auf. Der zweite Referenzoszillator 4 ist vorzugsweise dazu ausgebildet, ein zweites Ausgangssignal 5 zu erzeugen, das ein geringeres Phasenrauschen als das erste Ausgangssignal 3 des ersten Referenzoszillator 2 (jeweils im Freilauf des Referenzoszillators 2, 4) aufweist.

Ein freilaufender Referenzoszillator 2, 4 ist in diesem Zusammenhang ein Referenzoszillator 2, 4, der ungeregelt ist, im Falle des zweiten Referenzoszillators 4 also bei autark betriebenem / ungeregeltem, also nicht durch den Phasenregelkreis geregelten zweiten Referenzoszillator 4.

Der zweite Referenzoszillator 4 weist vorzugsweise eine für das zweite Ausgangssignal 5 maßgebliche Signalerzeugungseigenschaft auf bzw. das durch den Referenzoszillator 4 erzeugbare zweite Ausgangssignal 5 weist (im Freilauf) eine Eigenschaft auf, die besser ist als die entsprechende Signaleigenschaft des ersten Referenzoszillators 2 bzw. dessen ersten Ausgangssignals 3. Der zweite Referenzoszillator 4 ist nicht zwingend ein Quarzoszillator, auch wenn dies besonders bevorzugt ist.

Ganz besonders bevorzugt weist der zweite Referenzoszillator 4 ein Phasenrauschen auf, das geringer ist als das Phasenrauschen des ersten Referenzoszillators 2. Hierzu wird zwar ganz bevorzugt eine Stabilisierung mittels eines Schwingquarzes eingesetzt, wodurch der zweite Referenzoszillator 4 ein Quarzoszillator ist, dies ist jedoch nicht zwingend, sofern die Signaleigenschaft, insbesondere das Phasenrauschen, durch etwaige andere Maßnahmen bei dem zweiten Referenzoszillator 4 oder in dessen Ausgangssignal 5 im Freilauf besser ist als bei dem ersten Referenzoszillator 2 bzw. dessen Ausgangssignal 3.

Die Referenzoszillatoranordnung 1 weist vorzugsweise einen PLL bzw. Phasenregelkreis 6 auf. Dieser Phasenregelkreis 6 ist zur Regelung der Frequenz und/oder Phase des zweiten Referenzoszillators 4 auf die Frequenz und/oder Phase des ersten Referenzoszillator 2 ausgebildet. Genauer gesagt ist der Phasenregelkreis 6 dazu ausgebildet, auf Basis des ersten Ausgangssignals 3 des ersten Referenzoszillators 2 den zweiten Referenzoszillator 4 derart zu regeln, dass die Frequenz und/oder Phase des zweiten Ausgangssignals 5 des zweiten Referenzoszillators 4 der Frequenz und/oder Phase des ersten Ausgangssignals 3 des ersten Referenzoszillators 2 (insbesondere trägernah / im Frequenzbereich unmittelbar um die Schwingfrequenz) zumindest im Wesentlichen entspricht.

Der Phasenregelkreis 6 ist damit vorzugsweise dazu ausgebildet, die Phase des zweiten Ausgangssignals 5 des zweiten Referenzoszillators 4 auf die Phase des ersten Ausgangssignals 3 des ersten Referenzoszillators 2 zu disziplinieren. Auf diese Weise erhält das zweite Ausgangssignal 5 vorzugsweise in Hinblick auf die Frequenzstabilität die Eigenschaften des ersten Ausgangssignals 3 des ersten Referenzoszillators 2.

Der erste Referenzoszillator 2 weist (im Freilauf) eine bessere Frequenzstabilität als der zweite Referenzoszillator 4 auf. Entsprechend wird die Frequenzstabilität des zweiten Referenzoszillators 4 durch Disziplinierung mit dem ersten Ausgangssignal 3 des ersten Referenzoszillators 2 über den Phasenregelkreis 6 verbessert.

Zusätzlich weist der zweite Referenzoszillator 4 bzw. dessen zweites Ausgangssignal 5 (insbesondere trägerfern / abseits der Schwingfrequenz) ein besseres Phasenrauschen als der erste Referenzoszillator 2 bzw. dessen erstes Ausgangssignal 3 auf. Diese Eigenschaften beziehen sich wiederum vorzugsweise auf den Fall des jeweils freilaufenden Referenzoszillators 2, 4.

Der Phasenregelkreis 6 ist vorzugsweise dazu ausgebildet, den zweiten Referenzoszillator 4 bzw. dessen Ausgangssignal 5 nun im Frequenzbereich unmittelbar um die Frequenz des ersten Ausgangssignals 3 bzw. des ersten Referenzoszillators 2 zu disziplinieren, also dem zweiten Referenzoszillator 4 bzw. dessen zweiten Ausgangssignal 5 die Eigenschaften der Frequenz bzw. Frequenzstabilität des ersten Referenzoszillators 2 bzw. des ersten Ausgangssignals 3 aufzuprägen.

Dies ermöglicht es in vorteilhafter Weise, ein zweites Ausgangssignal 5 durch den zweiten Referenzoszillator 4 zu erzeugen, das in Hinblick auf die Frequenzstabilität die Eigenschaften des ersten Referenzoszillators 2 bzw. dessen ersten Ausgangssignals 3 und darüber hinaus abseits der Frequenz des ersten und/oder zweiten Ausgangssignals 3, 5 die verbesserten Schwingeigenschaften des zweiten Referenzoszillators 4 bzw. des zweiten Ausgangssignals 5, insbesondere das bessere bzw. geringere Phasenrauschen, aufweist.

Daher ermöglicht die Kopplung des ersten Referenzoszillators 2 mit dem zweiten Referenzoszillator 4 über den Phasenregelkreis 6 die Erzeugung des zweiten Ausgangssignals 5 mit Eigenschaften, die besser sind, als die Eigenschaften des ersten Ausgangssignals 3 und des zweiten Ausgangssignals 5 im Fall freilaufender Referenzoszillatoren 2, 4.

Die verbesserte Frequenzstabilität des ersten Referenzoszillators 2 basiert im Darstellungsbeispiel vorzugsweise vorrangig auf der bevorzugt vorgesehenen Temperaturkompensation des ersten Referenzoszillators 2, wodurch eine Temperaturdrift der Frequenz und/oder Phase des ersten Ausgangssignals 3 kompensiert wird. Alternativ oder zusätzlich kann der erste Referenzoszillator 2 andere oder ergänzende Maßnahmen zur Verringerung oder Kompensation von Frequenzänderungen aufweisen. Diese bzw. entsprechende Maßnahmen sind bei dem zweiten Referenzoszillator 2 vorzugsweise nicht realisiert. Dieser ist also vorzugsweise frei von einer Temperaturkompensation.

Zumindest der zweite Referenzoszillator 4 ist vorzugsweise abstimmbar, kann also in Bezug auf die Frequenz und/oder Phase des durch den zweiten Referenzoszillator 4 erzeugbaren zweiten Ausgangssignals 5 gesteuert oder geregelt werden. Eine entsprechende Regelung erfolgt vorliegend vorzugsweise durch den Phasenregelkreis 6, in den der zweite Referenzoszillator 4 eingebunden ist.

Konkret weist der Phasenregelkreis 6 eine Rückkopplung 7 für das zweite Ausgangssignal 5 auf. Die Rückkopplung 7 kann grundsätzlich einen Teiler aufweisen, was im Darstellungsbeispiel und bei der vorschlagsgemäßen Referenzoszillatoranordnung 1 nicht der Fall und entsprechend nicht dargestellt ist.

Der Phasenregelkreis 6 weist vorzugsweise einen Phasen-Frequenz-Detektor 8 auf. Dieser ist dazu ausgebildet, das über die Rückkopplung 7 an einem Rückkoppeleingang 9 des Phasen-Frequenz-Detektors 8 anliegende (optional geteilte) zweite Ausgangssignal 5 mit einem an einem Referenzeingang 10 des Phasen-Frequenz-Detektors 8 anliegenden Signal, vorzugsweise dem ersten Ausgangssignal 3 des ersten Referenzoszillator 2, zu vergleichen.

Hierdurch wird ein Phasen-Frequenz-Detektor-Ausgangssignal, im Folgenden PFD-Ausgangssignal 11 genannt, gebildet. Dieses kann durch Filtern mit einem Schleifenfilter 12 zu einer Steuergröße 13 des Phasenregelkreises 6 verarbeitet werden, die zur Steuerung, Regelung und/oder Abstimmung des zweiten Referenzoszillators 4 mit diesem gekoppelt ist.

Der Phasenregelkreis 6 ist hierbei vorzugsweise dazu eingerichtet, eine Frequenz- und/oder Phasendifferenz zwischen dem Rückkoppeleingang 9 und dem Referenzeingang 10 zu reduzieren bzw. zu kompensieren, also ein PFD-Ausgangssignal 11 zu erzeugen, das mit dem Schleifenfilter 12 gefiltert den zweiten Referenzoszillator 4 in entsprechender Weise regelt, um die Phasen- und/oder Frequenzabweichung zwischen dem Rückkoppeleingang 9 und dem Referenzeingang 10 bzw. hiermit gekoppelten Signalen zu minimieren.

Hierdurch ermöglicht der Phasenregelkreis 6 die Regelung des zweiten Referenzoszillators 4 zur Erzeugung des zweiten Ausgangssignals 5, sodass in der durch den Phasenregelkreis 6 und insbesondere durch das Schleifenfilter 12 vorgegebenen Bandbreite (Schleifenbandbreite FB) das zweite Ausgangssignal 5 (um die Frequenz des Signals am Referenzeingang 10 bzw. des ersten Ausgangssignals 3) zumindest im Wesentlichen dem an dem Referenzeingang 10 anliegenden Signal, bevorzugt dem ersten Ausgangssignal 3 des ersten Referenzoszillators 2, entspricht.

Der Phasenregelkreis 6 und/oder das Schleifenfilter 12 ist/sind vorzugsweise dazu ausgebildet, den zweiten Referenzoszillator 4 bzw. dessen zweites Ausgangssignal 5 nur bei oder im unmittelbaren Umfeld der Frequenz des ersten Referenzoszillators 2 bzw. der Frequenz des ersten Ausgangssignals 3 zu regeln. Hierzu kann insbesondere ein schmalbandiges Schleifenfilter 12 vorgesehen sein, sodass außerhalb der Bandbreite des Schleifenfilters 12 die Freilauf-Eigenschaften des zweiten Referenzoszillators 4 das zweite Ausgangssignal 5 prägen.

Da der zweite Referenzoszillator 4 in diesen Bereichen vorzugsweise qualitative Vorteile gegenüber dem ersten Referenzoszillator 2 aufweist, werden die Eigenschaften des ersten Referenzoszillators 2 und des zweiten Referenzoszillators 4 durch den Phasenregelkreis 6 in synergistischer Weise zu dem zweiten Ausgangssignal 5 kombiniert.

Insbesondere wird als Schleifenfilter 12 ein Filter zweiter oder höherer Ordnung eingesetzt.

Die 3-dB-Bandbreite des Schleifenfilters 12 bzw. des Phasenregelkreises 6 kann beispielsweise weniger als 1 MHz, vorzugsweise weniger als 100 kHz oder 10 kHz, insbesondere weniger als 1 kHz betragen. Es kann vorgesehen sein, dass die 3-dB-Bandbreite 500 Hz, 200 Hz oder 100 Hz unterschreitet.

Bei dem Schleifenfilter 12 handelt es sich bevorzugt um ein Tiefpassfilter. Insbesondere handelt es sich um ein Tiefpassfilter zweiter oder höherer Ordnung. Hier sind jedoch auch andere Lösungen möglich.

Die Referenzoszillatoranordnung 1 ist vorzugsweise eine zusammenhängende elektronische Baugruppe. Insbesondere bilden jedenfalls der erste Referenzoszillator 2 und der zweite Referenzoszillator 4 Teile desselben Moduls bzw. sind drahtgebunden miteinander gekoppelt, Teil derselben elektrischen Schaltung, durch dieselbe Stromversorgung mit elektrischer Energie versorgt, im selben Gehäuse untergebracht, auf demselben Träger und/oder miteinander verbundenen bzw. auf miteinander befestigten Trägern vorgesehen, fest, starr bzw. unbewegbar zueinander angeordnet und/oder der erste Referenzoszillator 2 ist nicht lediglich drahtlos mit dem zweiten Referenzoszillator 4 gekoppelt.

Die vorschlagsgemäße Referenzoszillatoranordnung 1 weist vorzugsweise einen Kalibriereingang 14 für ein Kalibriersignal 15 auf. Das Kalibriersignal 15 kann von einer Kalibriersignalquelle 16 stammen. Beispielsweise handelt es sich um ein von einem Satellitennavigations-Signal 17 wie einem GPS-Signal abgeleiteten Kalibriersignal 15. Alternativ oder zusätzlich kann das Kalibriersignal 15 ein Netzwerksynchronisationssignal (beispielsweise Synchronous Ethernet (SyncE), IEEE 1588 o. dgl.) und/oder ein (Funk-) Zeitsignal sein oder aufweisen oder hiervon abgeleitet sein.

Der Referenzoszillatoranordnung 1 kann der Kalibriersignalquelle 16 zugeordnet sein oder die Referenzoszillatoranordnung 1 kann die Kalibriersignalquelle 16 aufweisen.

Die Referenzoszillatoranordnung 1 ist vorzugsweise für einen autarken Betrieb ausgelegt, kann also das zweite Ausgangssignal 5 in der beschriebenen Weise bilden, wenn lediglich eine Stromversorgung bereitgestellt ist. Insbesondere werden keine externen Signale wie das Kalibriersignal 15 benötigt, damit die vorschlagsgemäße Referenzoszillatoranordnung 1 funktionsfähig ist.

Das Kalibriersignal 15 kann geeignet sein, eine Frequenz und/oder Phase aufzuweisen oder vorzugeben, auf deren Basis die Referenzoszillatoranordnung 1 kalibrierbar sein kann. Insbesondere kann die Referenzoszillatoranordnung 1 dazu ausgebildet sein, die Frequenz und/oder Phase des ersten Referenzoszillators 2 an die des, bevorzugt externen, Kalibriersignals 15 anzupassen bzw. hiermit zu synchronisieren.

Im Darstellungsbeispiel wird das bereitgestellte Kalibriersignal 15 über einen Multiplexer 18 alternativ zum ersten Ausgangssignal 3 des ersten Referenzoszillators 2 an dem Referenzeingang 10 des Phasen-Frequenz-Detektors 8 des Phasenregelkreises 6 angelegt. Auf diese Weise synchronisiert der Phasenregelkreis 6 den zweiten Referenzoszillator 4 bzw. dessen Ausgangssignal 5 mit dem Kalibriersignal 15, wenn dieses mit dem Referenzeingang 10 gekoppelt ist.

Weiter kann die Referenzoszillatoranordnung 1 eine Steuereinrichtung 20 aufweisen. Die Steuereinrichtung 20 kann dazu ausgebildet sein, ein Auswahlsignal 21 bereitzustellen. Dieses kann den Multiplexer 18 so steuern, dass das Ausgangssignal 3 an den Referenzeingang 10 des Phasen-Frequenz-Detektors 8 angelegt wird, um den zweiten Referenzoszillator 4 bzw. dessen Ausgangssignal 5 hierauf zu synchronisieren. Die Steuereinrichtung 20 kann alternativ oder zusätzlich dazu ausgebildet sein, mit dem Auswahlsignal 21 den Multiplexer 18 so zu steuern, dass das Kalibriersignal 15 an den Referenzeingang 10 des Phasen-Frequenz-Detektors 8 angelegt wird, um den zweiten Referenzoszillator 4 bzw. dessen Ausgangssignal 5 hierauf zu synchronisieren.

Die Steuereinrichtung 20 kann eine Zeitbasis 20A, insbesondere Uhr, aufweisen. Diese Zeitbasis 20A, insbesondere Systemzeitbasis, kann mit einem weiteren Kalibriersignal 19 synchronisiert werden, beispielsweise einer Zeitinformation, die aus dem Satellitennavigations-Signal 17, einem Funkuhrsignal oder einem sonstigen Zeitreferenzsignal wie einem Netzwerk-Synchronisationssignal (insbesondere **IEEE** 1588 und/oder Synchronous Ethernet) abgeleitet oder hierdurch gebildet sein kann.

Alternativ oder zusätzlich kann die Steuereinrichtung 20 den Multiplexer 18 steuern, das Kalibriersignal 15 oder das erste Ausgangssignal 3 mit dem Referenzeingang 10 zu koppeln, insbesondere abhängig von dem Empfang des SatellitennavigationsSignals 17, der Zeitbasis 20A oder einer Alternative hierzu, von einem Status der Kalibriersignalquelle 16 und/oder nach Ablauf einer Zeitspanne seit der letzten Kalibrierung bzw. bei Vorliegen eines sonstigen Kriteriums in Zusammenhang mit einem Erfordernis zur Kalibrierung.

Die Steuereinrichtung 20 ist vorzugsweise zur Kalibrierung des ersten Referenzoszillators 2 ausgebildet. Hierdurch kann ein Frequenz- und/oder Phasenunterschied zwischen der Frequenz und/oder Phase des ersten Ausgangssignals 3 des ersten Referenzoszillator 2 und der Frequenz und/oder Phase des Kalibriersignals 15 verringert oder kompensiert werden.

Mit anderen Worten kann ein Frequenzunterschied zwischen der Frequenz des ersten Ausgangssignals 3 des ersten Referenzoszillator 2 und der Frequenz des Kalibriersignals 15 verringert oder kompensiert werden bzw. es kann ein Phasenunterschied zwischen der Phase des ersten Ausgangssignals 3 des ersten Referenzoszillator 2 und der Phase des Kalibriersignals 15 verringert oder kompensiert werden.

Zur Kalibrierung ist der erste Referenzoszillator 2 vorzugsweise abstimmbar. Der erste Referenzoszillator 2 ist insbesondere als digital oder analog frequenz-abstimmbarer Referenzoszillator 2 ausgebildet. Hierdurch kann die Frequenz und/oder Phasenlage des ersten Ausgangssignals 3 des ersten Referenzoszillators 2 an das Kalibriersignal 15 angepasst werden. Dies ermöglicht einerseits eine verbesserte absolute Frequenzgenauigkeit der Referenzoszillatoranordnung 1 und andererseits die Synchronisation mehrerer Referenzoszillatoranordnungen 1, worauf später noch eingegangen wird.

Die Steuereinrichtung 20 ist vorzugsweise dazu ausgebildet, das Kalibriersignal 15 mit dem Phasenregelkreis 6 zu koppeln, sodass der Phasenregelkreis 6 des zweiten Referenzoszillators 4 bzw. dessen Ausgangssignal 5 mit dem Kalibriersignal 15 synchronisiert wird bzw. synchronisierbar ist. Insbesondere kann der Multiplexer 18 durch die Steuereinrichtung 20 mit dem Auswahlsignal 21 entsprechend gesteuert werden.

Besonders bevorzugt ist die Referenzoszillatoranordnung 1 bzw. die Steuereinrichtung 20 dazu ausgebildet, Unterschiede zwischen Frequenzen und/oder Phasen des Kalibriersignals 15 einerseits und des Ausgangssignals 3 des ersten Referenzoszillators 2 andererseits oder hierzu korrespondierende Werte oder Parameter zu ermitteln.

Alternativ oder zusätzlich kann die Steuereinrichtung 20 dazu ausgebildet sein, durch Kalibrierung des ersten Referenzoszillators 2 Unterschiede in der Frequenz und/oder Phase zwischen dem Kalibriersignal 15 und dem Ausgangssignal 3 des ersten Referenzoszillators 2 zu minimieren. Hierzu kann die Steuereinrichtung 20 ein Abstimmsignal 22 erzeugen, das, optional über eine Frequenzsteuereinrichtung 23 - im vorliegenden Fall eine digitale Frequenzkontrolleinheit -, den ersten Referenzoszillator 2 abstimmt.

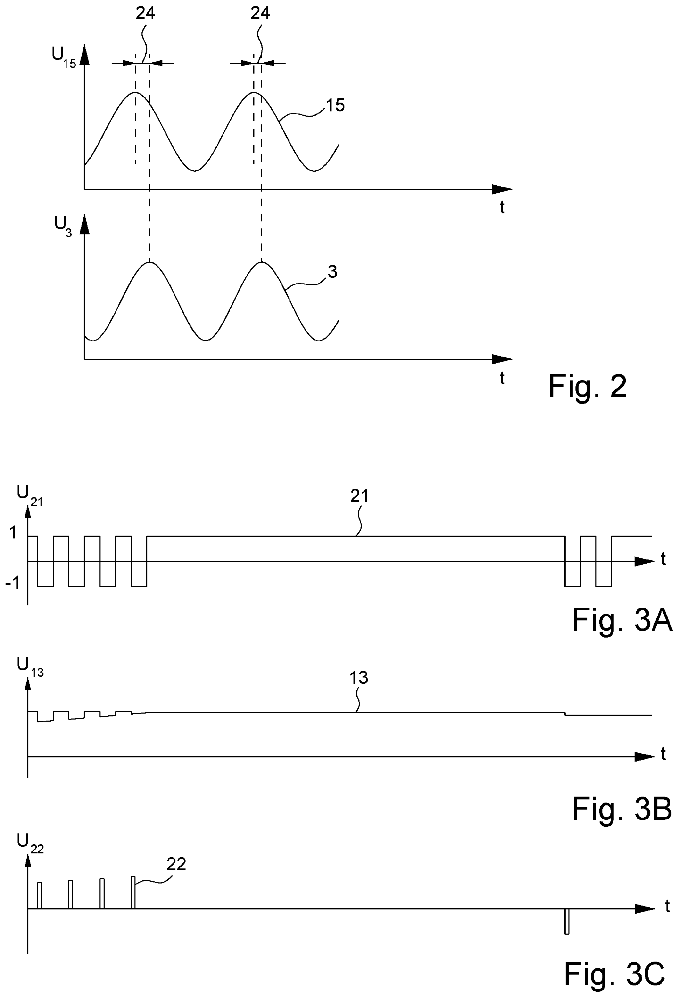

Fig. 2 zeigt in einem vereinfachten, schematischen Diagramm Beispiele für eine Spannung U₁₅ des Kalibiersignals 15 und eine Spannung U₃ des ersten Ausgangssignals 3 des ersten Referenzoszillators 2 über die Zeit t im Vergleich. **Im** Darstellungsbeispiel sind die Spannung U₁₅ des Kalibriersignals 15 und die Spannung U₃ des ersten Ausgangssignals 3 noch nicht synchronisiert, sodass sich aufgrund einer Frequenzabweichung die Phasendifferenz 24 zwischen den Spannungen U₁₅, U₃ verändert.

Eine Kalibrierung des ersten Referenzoszillators 2 führt vorzugsweise dazu, dass das erste Ausgangssignal 3 des ersten Referenzoszillators 2 zumindest im Wesentlichen frequenz- und/oder phasensynchron mit dem Kalibriersignal 15 wird.

Weiter bezugnehmend auf die Fig. 1 ist die Referenzoszillatoranordnung 1 und insbesondere die Steuereinrichtung 20 der Referenzoszillatoranordnung 1 vorzugsweise dazu ausgebildet, die Kalibrierung des ersten Referenzoszillators 2 auf Basis einer bzw. der Steuergröße 13 des Phasenregelkreises 6 zu bewirken. Hierzu ist vorzugsweise vorgesehen, dass die Steuergröße 13 des Phasenregelkreises 6 bei mit dem Phasenregelkreis 6 bzw. seinem Referenzeingang 10 gekoppeltem Kalibriersignal 15 ermittelt wird. Auf dieser Basis kann der erste Referenzoszillator 2 so abgestimmt werden, dass die Steuergröße 13 bei mit dem Phasenregelkreis 6 gekoppeltem ersten Referenzoszillator 2, also am Referenzeingang 10 anliegendem ersten Ausgangssignal 3, zumindest im Wesentlichen der Steuergröße 13 bei mit dem Phasenregelkreis 6 gekoppeltem Kalibriersignal 15 entspricht.

Dies bewirkt vorzugsweise einen Frequenzabgleich des internen, für den Inselbetrieb genutzten ersten Referenzoszillators 2 mit dem zumindest zeitweise, insbesondere am Referenzeingang 10, anliegenden bzw. anlegbaren externen Kalibriersignal 15 der (externen) Kalibriersignalquelle 16.

Konkret kann also bei an dem Referenzeingang 10 anliegendem Kalibriersignal 15 die Steuergröße 13 ermittelt werden, insbesondere durch die Steuereinrichtung 20, und im Anschluss kann der erste Referenzoszillator 2 bzw. sein Ausgangssignal 3 mit dem Referenzeingang 10 gekoppelt werden, wobei sich zunächst eine abweichende Steuergröße 13 einstellen kann. Die Referenzoszillatoranordnung 1 bzw. die Steuereinrichtung 20 ist dann dazu ausgebildet, den ersten Referenzoszillator 2 - insbesondere über das Abstimmsignal 22 - so abzustimmen, dass sich dieselbe Steuergröße 13 ergibt, wie sie bei mit dem Referenzeingang 10 gekoppeltem Kalibriersignal 15 gewesen ist. Auf diese Weise kann der erste Referenzoszillator 2 entsprechend mit dem Kalibriersignal 15 synchronisiert werden.

Grundsätzlich kann die Synchronisation des ersten Referenzoszillators 2 bzw. dessen Ausgangssignals 3 mit dem Kalibriersignal 15 bzw. über das weitere Kalibriersignal 19 - insbesondere mit dem Satellitennavigations-Signal 17, einem Funkuhr-Referenzsignal, einem sonstigen Funk-Zeitsignal und/oder einem Netzwerkprotokoll bzw. Netzwerkzeitprotokoll-Signal - auch anderweitig oder direkt erfolgen.

Die Fig. 3A bis 3C zeigen beispielhaft Diagramme des Auswahlsignals 21 (seiner Spannung U₂₁) über der Zeit t, der Steuergröße 13 (seiner Spannung U₁₃) des Phasenregelkreises 6 bzw. zweiten Referenzoszillators 4 über der Zeit t und des Abstimmsignals 22 (seiner Spannung U₂₂) über der Zeit t.

Besonders bevorzugt erfolgt die Abstimmung durch ein Abstimmverfahren, zu dessen Durchführung die Referenzoszillatoranordnung 1 ausgebildet sein kann und das auch einen unabhängigen Aspekt der vorliegenden Erfindung bilden kann.

Die Referenzoszillatoranordnung 1 kann mindestens zwei Betriebsmodi unterstützen, wobei in einem ersten Betriebsmodus der Referenzeingang 10 mit dem ersten Ausgangssignal 3 des ersten Referenzoszillators 2 gespeist wird (Normalbetrieb) und in einem zweiten Betriebsmodus mit dem Kalibriersignal 15 (Kalibrierbetrieb). Dies kann über das Auswahlsignal 21 mit dem Multiplexer 18 bestimmt werden.

Im Darstellungsbeispiel gemäß Fig. 3A ist das Auswahlsignal 21 beispielhaft digital und steuert den Multiplexer 18 bei 'logisch 1' so, dass dieser das erste Ausgangssignal 3 zum Referenzeingang 10 leitet (erster Betriebsmodus) und bei 'logisch -1' so, dass dieser das Kalibriersignal 15 zum Referenzeingang 10 leitet (zweiter Betriebsmodus). Entsprechend wird der zweite Referenzoszillator 4 auf das am Referenzeingang 10 anliegende Signal gelockt, übernimmt also aufgrund der Regelung des Phasenregelkreises 6 dessen Frequenz und Phase. Dies ist im Beispiel bei 'logisch 1' die Frequenz und Phase des ersten Ausgangssignals 3 und bei 'logisch -1' die Frequenz und Phase des Kalibriersignals 15. Zu der Frequenz des zweiten Ausgangssignals 5 korrespondiert die Steuergröße 13, sodass bei konstanter Steuergröße 13 die Frequenz des zweiten Ausgangssignals 5 unveränderlich ist bzw. sich nicht ändert. Im Umkehrschluss ist der erste Referenzoszillator 2 in diesem Fall auf das Kalibriersignal 15 kalibriert - diese weisen also vorzugsweise dieselbe Frequenz auf. Die Form des Auswahlsignals 21 ist beispielhaft und kann natürlich auch anderer Natur sein.

Vorzugsweise wird zum Abstimmen des ersten Referenzoszillators 2, insbesondere mehrfach, zwischen dem ersten und dem zweiten Betriebsmodus gewechselt. Der Referenzeingang 10 der Referenzoszillatoranordnung 1 wird also abwechselnd mit dem ersten Ausgangssignal 3 des ersten Referenzoszillators 2 und mit dem Kalibriersignal 15 gespeist.

Der zweite Referenzoszillator 4 wird entsprechend durch den Phasenregelkreis 6 so gesteuert, dass dessen Frequenz bzw. Phase abwechselnd zumindest im Wesentlichen mit der Frequenz bzw. Phase des ersten Ausgangssignals 3 des ersten Referenzoszillators 2 und mit der Frequenz bzw. Phase des Kalibriersignals 15 übereinstimmt. Der zweite Referenzoszillator 4 kann hierbei als sog. Jitter Cleaner eingesetzt werden.

Hierbei wird die Steuergröße 13, insbesondere Tuningspannung, des zweiten Referenzoszillators 4 überwacht, während der Referenzeingang 10 abwechselnd mit dem ersten Ausgangssignal 3 des ersten Referenzoszillators 2 und mit dem Kalibriersignal 15 gespeist wird.

Weiter wird das Abstimmsignal 22 nachgeführt, insbesondere geregelt, sodass die Steuergröße 13 bei dem Wechsel zumindest im Wesentlichen unverändert bleibt.

Da die Steuergröße 13 des zweiten Referenzoszillators 4 dessen Frequenz bestimmt, bleibt die Steuergröße 13 dann bei dem Wechsel zumindest im Wesentlichen unverändert, wenn die Frequenz des zweiten Referenzoszillators 4 auch konstant ist. Da die Frequenz des zweiten Referenzoszillators 4 bei Kopplung des Ausgangssignals 3 mit dem Referenzeingang 10 dem des ersten Referenzoszillators 2 entspricht und die Frequenz so abgestimmt wird, dass sie bei Umschaltung gleich bleibt, erzeugt der erste Referenzoszillator 2 nach Durchführung des Verfahrens die Frequenz des Kalibriersignals 15.

Damit wird über die Steuergröße 13 mittelbar die Frequenz des ersten Referenzoszillators 2 auf die des Kalibriersignals 15 kalibriert.

Mit anderen Worten wird das Tuningspannungssignal (Steuergröße 13) des zweiten Referenzoszillators 4 ausgewertet und mit dem Multiplexer 18 der Referenzeingang 10 zwischen dem Kalibriersignal 15 einer externen Quelle und dem ersten Ausgangssignal 3 des ersten Referenzoszillators 2 umgeschaltet. Dabei wird die Frequenz des ersten (internen) Referenzoszillators 2 an die des externen Kalibriersignals 15 (von einem externen Referenzoszillator) angeglichen, indem der interne erste Referenzoszillator 2 so lange in der Frequenz verändert wird, bis beim Umschalten des Multiplexers 18 keine Veränderung im Tuningspannungssignal (Steuergröße 13) mehr festgestellt wird.

Im Normalbetrieb wird der interne erste Referenzoszillator 2 in der Frequenz auf das Kalibriersignal 15 (eines externen Referenzoszillators) geregelt und danach im Freilauf betrieben. Hierbei handelt es sich um einen Inselbetrieb mit dem ersten Referenzoszillator 2, der aber mit externem Frequenznormal bzw. dem Kalibriersignal 15 (eines externen Referenzoszillators) kalibrierbar ist. Der zweite Referenzoszillator 4 wird vorzugsweise als Jitter Cleaner eingesetzt, um das trägerferne Rauschen des ersten Referenzoszillators 2 zu verbessern.

In einem anderen, alternativen oder zusätzlichen (dritten) Betriebsmodus, auch Verbundbetrieb genannt, wird der erste Referenzoszillator 2 vorzugsweise nicht verwendet und stattdessen der zweite Referenzoszillator 4 auf das Kalibriersignal 15 (eines externen Referenzoszillators bzw. der Kalibriersignalquelle 16) gelockt. Hierbei kann der zweite Referenzoszillator 4 als Jitter Cleaner für das Kalibriersignal 15 genutzt werden. Dieser Betriebsmodus kann dem zweiten Betriebsmodus entsprechen, mit dem Unterschied, dass der Wechsel des Referenzeingangs 10 zum ersten Ausgangssignal 3 des ersten Referenzoszillators 2 entfällt.

Da in diesem anderen, alternativen oder zusätzlichen (dritten) Betriebsmodus der zweite Referenzoszillator 4 (dauerhaft) auf das Kalibriersignal 15 bzw. die (externe) Kalibriersignalquelle 16 vorzugsweise nach Frequenz und Phase gelockt wird - insbesondere dadurch, dass das Kalibriersignal 15 dauerhaft an den Referenzeingang 10 angelegt wird - können mehrere Referenzoszillatoranordnungen 1 bzw. Systeme damit, vorzugsweise als Verbund, phasenstarr zusammen bzw. zueinander betrieben werden.

Im Darstellungsbeispiel gemäß Fig. 1 kann ein Netzwerksynchronisationssignal oder GPS-Signal als Beispiel für ein Satellitennavigation-Signal 17 Zeitsynchronisationsinformationen aufweisen, die durch die Kalibriersignalquelle 16 als Kalibriersignal 19 gegebenenfalls von der Steuereinrichtung 20 verarbeitet werden können.

Besonders bevorzugt weist die Steuereinrichtung 20 eine Zeitbasis 20A, insbesondere Uhr, auf, die weiter besonders bevorzugt mit dem Kalibriersignal 19 synchronisiert oder synchronisierbar ist. Insbesondere wird eine Systemzeit synchronisiert.

Mittels der Zeitbasis 20A können zeitlich synchronisierte Radarsignale 36 erzeugt werden. Hierzu kann die Steuereinrichtung 20 ein Radarmodul zur Erzeugung miteinander synchronisierter Radarsignale steuern (triggern). Insbesondere erfolgt dies derart, dass zeitgleiche Frequenzrampen erzeugt werden.

Der Takt für die Zeitbasis 20A wird vorzugsweise dem zweiten Ausgangssignal 5 entnommen bzw. das zweite Ausgangssignal 5 als Takt für die Zeitbasis 20A verwendet.

Das zweite Ausgangssignal 5 kann hierbei bevorzugt entweder durch Synchronisation des zweiten Referenzoszillators 4 auf das erste Ausgangssignal 3 oder auf das Kalibriersignal 15 einen Takt mit dessen Frequenz bereitstellen. Es kann hierbei über die Kalibriersignalquelle 16 alternativ nur oder zusätzlich die Zeit geliefert werden. Dann kann der Takt von einer sonstigen internen Quelle entnommen werden, also bevorzugt einem der Referenzoszillatoren 2, 4.

Über Netzwerk mittels SyncE für den Takt und/oder IEEE 1588 für die Zeitsynchronisation können auch beide Informationen direkt von einer externen Quelle (Kalibriersignalquelle 16) kommen und dann über die Jitter Cleaner PLL mit dem guten Phasenrauschen des zweiten Referenzoszillators 4 versehen genutzt werden.

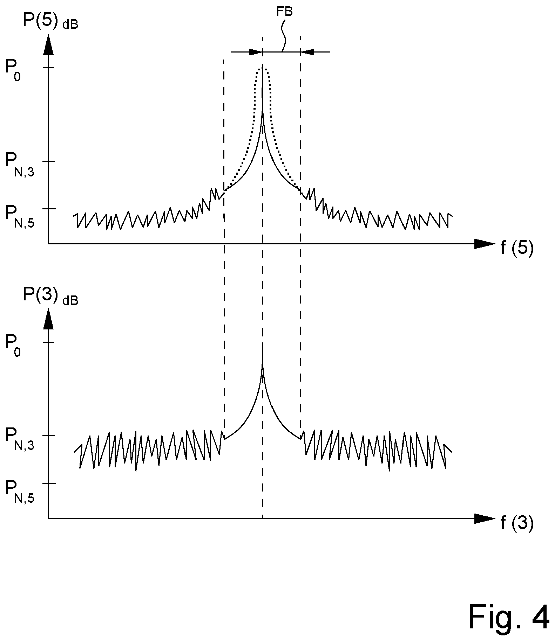

Über die synchronisierte Zeitbasis 20A in der Steuereinrichtung 20 können zwischen mehreren Radarsensoren Triggerzeitpunkte verabredet werden, zu denen dann Radarsignale, insbesondere Frequenzrampen, oder sonstige Ausgangssignale synchronisiert bzw. gestartet werden können. Fig. 4 zeigt in einem vereinfachten Diagramm eine spektrale Leistungsdichte P(5)_{dB}, P(3)_{dB} über der Frequenz des ersten Ausgangssignals 3 und des zweiten Ausgangssignals 5 im Vergleich. Gestrichelt im Diagramm des zweiten Ausgangssignals 5 ist die spektrale Leistungsdichte in dB über der Frequenz des freilaufenden zweiten Referenzoszillators 4 angedeutet.

Durch Einsatz des Phasenregelkreises 6 wird im Bereich der Frequenz des zweiten Ausgangssignals 5 diesem die Frequenzstabilität des ersten Ausgangssignals 3 des ersten Referenzoszillators 2 mittels der durch den Phasenregelkreis 6 bewirkten Regelungen aufoktroyiert, sodass die Frequenzstabilität des zweiten Referenzoszillators 4 um den Träger bzw. die (Mitten- bzw. Träger-) Frequenz herum auf das zweite Ausgangssignal 5 übertragen wird.

Abseits der (Mitten- bzw. Träger-) Frequenz bzw. außerhalb der Bandbreite FB des Schleifenfilters 12 weist das zweite Ausgangssignal 5 das gegenüber dem ersten Ausgangssignal 3 bevorzugt geringere Phasenrauschen bei einem Phasenrauschniveau P_{N,5} des freilaufenden zweiten Referenzoszillators 4 bzw. dessen zweiten Ausgangssignals 5 im Vergleich zu einem höheren Phasenrauschniveau P_{N,3} des ersten Referenzoszillators 2 bzw. dessen ersten Ausgangssignals 3 auf. Dies führt in synergistischer Weise zu der vorteilhaften Kombination von bevorzugten Eigenschaften beider Referenzoszillatoren 2, 4.

Der zweite Referenzoszillator 4 ist im Darstellungsbeispiel gemäß Fig. 1 mit einer Takteinrichtung 25 zur Bereitstellung eines von dem zweiten Ausgangssignal 5 des zweiten Referenzoszillators 4 abgeleiteten Taktsignals 29 gekoppelt. Hierbei kann vorgesehen sein, dass die Takteinrichtung 25 auf Basis des zweiten Ausgangssignals 5 ein oder mehrere Takte/Taktsignale 29 durch Teilung des zweiten Ausgangssignals 5 erzeugt bzw. die Takteinrichtung 25 hierzu ausgebildet ist.

Die Steuereinrichtung 20 kann ein Resetsignal 26 erzeugen, das über einen Reseteingang 27 der Takteinrichtung 25 die Takteinrichtung 25 zurücksetzen bzw. in einen bestimmten (Ausgangs-) Zustand versetzen kann. Auf diese Weise kann eine weitergehende Synchronisation, insbesondere mit dem Kalibriersignal 15, dem Satellitennavigations-Signal 17 und/oder dem weiteren Kalibriersignal 19 erfolgen.

Die Takteinrichtung 25 kann einen oder mehrere (Frequenz-) Teiler 28 aufweisen, über die ein Taktsignal 29 generiert werden kann. Das Taktsignal 29 kann unmittelbar durch das zweite Ausgangssignal 5 und/oder durch ein geteiltes Ausgangssignal 5 gebildet sein. Im Darstellungsbeispiel sind mehrere, insbesondere drei, Teiler 28 vorgesehen. Das Taktsignal 29 weist im Darstellungsbeispiel das zweite Ausgangssignal 5 sowie das geteilte zweite Ausgangssignal 5 auf. Hier sind jedoch auch andere Lösungen möglich.

Das Taktsignal 29 kann an einem Takteingang 30 eines (Radar-) Transceivers 31 anliegen bzw. hiermit gekoppelt sein. Der (Radar-) Transceiver 31 bildet vorzugsweise ein Teil einer Radarvorrichtung 32.

Die Radarvorrichtung 32 kann einen Radarempfänger 33 zum Empfang und zur Verarbeitung eines Empfangssignals 34 aufweisen.

Die Radarvorrichtung 32 weist vorzugsweise einen Radar-Signalgenerator 35 zur Erzeugung eines Radarsignals 36 auf. Insbesondere ist der Radar-Signalgenerator 35 zur Erzeugung von Radar-Signalen für FMCW-Radarsysteme ausgebildet, insbesondere zur Bildung sogenannter Frequenzrampen, also Radar-Signalen mit einer kontinuierlichen, stetigen und/oder linearen Frequenzänderung über der Zeit.

Der Radar-Signalgenerator 35 kann dazu ausgebildet sein, auf Basis des zweiten Ausgangssignals 5 des Referenzoszillators 4 und/oder auf Basis des hiervon abgeleiteten bzw. des hierdurch gebildeten Taktsignals 29 das Radarsignal 36 zu erzeugen.

Der Radar-Signalgenerator 35 weist vorzugsweise einen insbesondere spannungsgesteuerten Oszillator auf. Hierbei handelt es sich weiter bevorzugt um einen quarzfreien bzw. nicht direkt quarzstabilisierten Oszillator.

Der Oszillator des Radar-Signalgenerator 35 erzeugt vorzugsweise eine Frequenz oder ist dazu ausgebildet, die höher ist als die Frequenz des ersten Ausgangssignals 3 und/oder des zweiten Ausgangssignals 5. Der Oszillator des Radar-Signalgenerator 35 erzeugt vorzugsweise eine Frequenz oder ist dazu ausgebildet, die ein Vielfaches der Frequenz des ersten Ausgangssignals 3 und/oder des zweiten Ausgangssignals 5 entspricht. Der Oszillator des Radar-Signalgenerator 35 ist vorzugsweise ein Millimeterwellenoszillator bzw. Oszillator zur Erzeugung von Frequenzen von mehr als 5 GHz, vorzugweise mehr als 10 GHz, insbesondere mehr als 20 GHz oder 30 GHz.

Der erste Referenzoszillator 2 und/oder der zweite Referenzoszillator 4 erzeugen vorzugsweise eine Frequenz oder ist/sind dazu ausgebildet, die ein Bruchteil der durch den Radar-Signalgenerator 35 bzw. durch den Oszillator des Radar-Signalgenerators 35 erzeugten Frequenz (Frequenz des Radarsignals 38) entspricht. Der erste Referenzoszillator 2 und/oder der zweite Referenzoszillator 4 kann im Wesentlichen dieselbe und/oder eine Frequenz unterhalb von 20 GHz oder 30 GHz, vorzugweise unterhalb von 10 GHz, insbesondere unterhalb von 5 GHz erzeugen. Besonders bevorzugt liegt die Frequenz des ersten Referenzoszillators 2 und/oder des zweiten Referenzoszillators 4 bzw. deren Ausgangssignal(e) 3, 5 im Megahertzbereich.

Der Oszillator des Radar-Signalgenerator 35 wird vorzugsweise auf Basis des zweiten Ausgangssignals 5 des Referenzoszillators 4 und/oder auf Basis des hiervon abgeleiteten bzw. des hierdurch gebildeten Taktsignals 29 gesteuert, synchronisiert und/oder stabilisiert oder die Refernzoszillatoranordnung 1 bzw. das Radarsystem 45 ist dazu ausgebildet.

Hierzu kann der Radar-Signalgenerator 35 einen Phasenregelkreis zur Regelung des insbesondere spannungsgesteuerten Oszillators des Radar-Signalgenerators 35 aufweisen. Dieser Phasenregelkreis des Radar-Signalgenerators ist weiter bevorzugt zur Regelung des Oszillators des Radar-Signalgenerators 35 auf das zweite Ausgangssignals 5 des zweiten Referenzoszillators 4 und/oder auf das hiervon abgeleitete Taktsignal 29 ausgebildet.

Der Phasenregelkreis des Radar-Signalgenerators 35 regelt also vorzugsweise die Frequenz eines Ausgangssignals des Oszillators des Radar-Signalgenerators 35 auf die Frequenz des zweiten Ausgangssignals 5 des zweiten Referenzoszillators 4 und/oder des hiervon abgeleiteten Taktsignals 29. Alternativ oder zusätzlich regelt der Phasenregelkreis des Radar-Signalgenerators 35 die Phase eines Ausgangssignals des Oszillators des Radar-Signalgenerators 35 auf die Frequenz des zweiten Ausgangssignals 5 des zweiten Referenzoszillators 4 und/oder des hiervon abgeleiteten Taktsignals 29.

Durch den Phasenregelkreis des Radar-Signalgenerators 35 können dem Oszillator des Radar-Signalgenerators 35 die Eigenschaften des zweiten Ausgangssignals 5 aufgeprägt werden bzw. der Radar-Signalgenerator 35 und/oder die Radarvorrichtung 32 ist hierzu ausgebildet. Entsprechend weist das durch den Oszillator des Radar-Signalgenerators 35 erzeugte Radarsignal 36 vorzugsweise das durch den zweiten Referenzoszillator 4 erzeugte (geringe) Phasenrauschen des zweiten Ausgangssignals 5 und, vorzugsweise, weiter die dem zweiten Referenzoszillator 4 vom ersten Referenzoszillator 2 aufgeprägte Temperaturstabilität auf.

Der Radar-Signalgenerator 35 ist vorzugsweise dazu ausgebildet, den Oszillator des Radar-Signalgenerator 35 so zu steuern bzw. zu regeln, dass dieser das Radarsignal 36, insbesondere FMCW-Frequenzrampen, erzeugt. Das Radarsignal 36 weist hierbei aufgrund der vorliegenden Erfindung eine besonderes hohe Präzision und Stabilität, also geringes trägernahes Phasenrauchen und gute Temperaturstabilität, auf.

Der Radarempfänger 33 kann einen Mischer 37 aufweisen, der auf Basis des Radarsignals 36 das Empfangssignal 34 verarbeitet oder hierzu ausgebildet ist. Insbesondere erzeugt der Mischer 37 aus dem Empfangssignal 34 durch Mischung mit dem Radarsignal 36 ein Zwischenfrequenzsignal, auch IF-Signal 38 genannt. Alternativ oder zusätzlich kann der Mischer 37 das Empfangssignal 34 mit dem Radarsignal 36 direkt in ein Basisband mischen, insbesondere wobei Signalanteile des Empfangssignals 34 bei gleicher Frequenz wie die des gleichzeitig vorliegenden Radarsignals 36 zu einem Gleichspannungsanteil (DC-Anteil) gemischt werden und/oder Anteile des Empfangssignals 34 mit von dem Radarsignal 36 abweichender Frequenz als Ausgangsignal des Mischers 37 bei der Differenzfrequenz aus der Frequenz des Empfangssignals 34 und der Frequenz des Radarsignals 36 ausgegeben werden.

Das Radarsignal 36 kann alternativ oder zusätzlich über einen Radarsender 39 als Sendesignal 40 ausgegeben bzw. emittiert werden.

Die Steuereinrichtung 20 kann optional ein Kontrollsignal 42 generieren bzw. dazu ausgebildet sein, über einen Kontrolleingang 43 des Radar-Signalgenerators 35 bzw. der Radarvorrichtung 32 die Erzeugung des Radarsignals 36 und/oder die Sende- und/oder Empfangsfunktion der Radarvorrichtung 32 zu steuern, insbesondere zu aktivieren und/oder deaktivieren, bevorzugt mittels des Kontrollsignals 42.

Bevorzugt wird das Kontrollsignal 42 aus der Zeitbasis 20A bzw. dem weiteren Kalibriersignal 19 bzw. dem Satellitennavigations-Signal 17 oder einem anderen Referenzsignal abgeleitet, sodass unterschiedliche Radar-Signalgeneratoren 35 synchronisierbar sind, insbesondere zur Bildung synchroner Radarsignale 36, insbesondere Frequenzrampen.

Die Radarvorrichtung 32, insbesondere der Radarempfänger 33 und/oder der Radarsender 39 kann/können eine oder mehrere Antennen 41 aufweisen. Im Darstellungsbespiel ist eine Antenne 41 zum Senden des Radarsignals 36 (als Sendesignal 40) und eine (andere) Antenne 41 zum Empfang des Empfangssignals 34 vorgesehen. Grundsätzlich kann hierfür jedoch auch dieselbe Antenne 41 verwendet werden oder es können mehrere oder eine mehrteilige Antenne hierfür vorgesehen sein.

Die vorschlagsgemäße Referenzoszillatoranordnung 1 weist vorzugsweise zumindest den ersten Referenzoszillator 2, den zweiten Referenzoszillator 4 und den Phasenregelkreis 6 auf. Weitere Komponenten sind bevorzugt, jedoch optional. Insbesondere kann vorgesehen sein, dass die Steuereinrichtung 20 oder Teile dieser und/oder die Radarvorrichtung 32 sowie die Referenzoszillatoranordnung 1 separate Teile bzw. gesonderte Funktionsblöcke bilden. Somit kann die Referenzoszillatoranordnung 1 zusammen mit der Radarvorrichtung 32 ein Radarmodul 44 bilden. Das Radarmodul 44 weist also vorzugsweise zumindest die Referenzoszillatoranordnung 1 aufweisend den ersten Referenzoszillator 2, den zweiten Referenzoszillator 4 und den Phasenregelkreis 6 sowie ergänzend die Radarvorrichtung 32 auf.

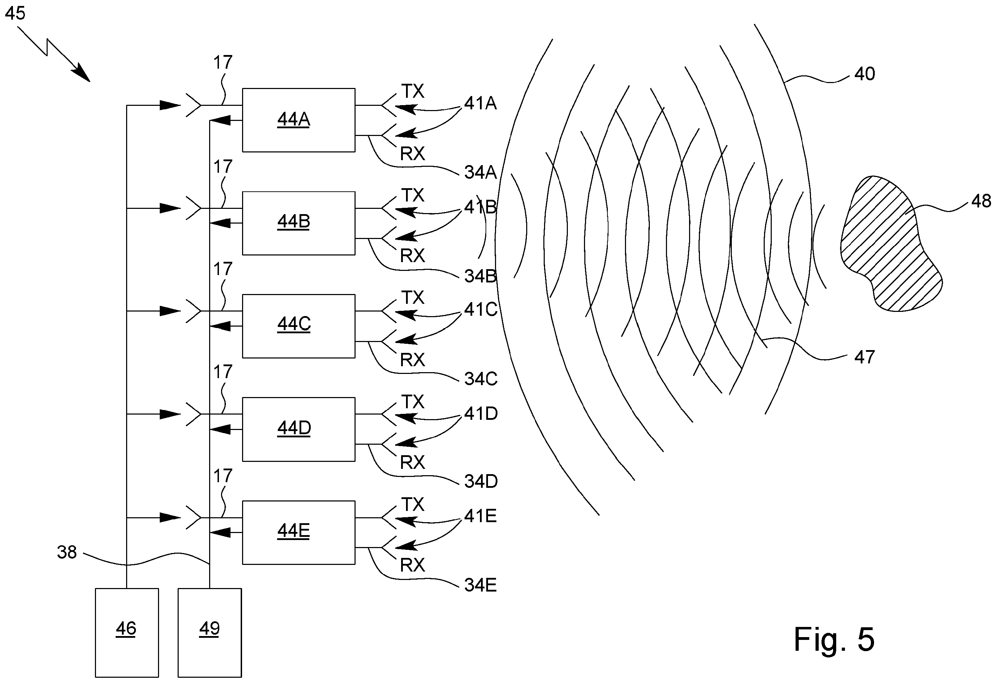

In Fig. 5 ist schematisch ein Radarsystem 45 dargestellt, das mehrere Referenzoszillatoranordnungen 1 bzw. Radarmodule 44 - aufweisend jeweils eine Referenzoszillatoranordnung 1 - aufweist. Zumindest eines der Radarmodule 44 weist eine vorschlagsgemäße Referenzoszillatoranordnung 1 mit dem ersten Referenzoszillator 2, dem zweiten Referenzoszillator 4 und dem Phasenregelkreis 6 auf. Grundsätzlich ist jedoch bevorzugt, dass auch mehrere oder alle Radarmodule 44 jeweils eine vorschlagsgemäße Referenzoszillatoranordnung 1 aufweisen.

Das Radarsystem 45 weist vorzugsweise eine Taktsynchronisationseinrichtung 46 zur Synchronisation der Referenzoszillatoranordnungen 1 der jeweiligen Radarmodule 44 auf. Insbesondere kann es sich hierbei um einen GPS-Satelliten oder eine sonstige Referenz bzw. Quelle für das Kalibriersignal 15 handeln.

Im Darstellungsbeispiel stellt die Taktsynchronisationseinrichtung 46 ein Satellitennavigations-Signal 17 wie ein GPS-, GLONASS-, Galileo- und/oder Beidou-Signal und/oder ein Netzwerksynchronisationssignal, insbesondere zur Synchronisation per IEEE 1588 und/oder Synchronous Ethernet, und/oder ein Funkzeitsignal wie ein DCF77-Signal zur Verfügung, mit dem die jeweiligen Radarmodule 44 bzw. deren Referenzoszillatoranordnungen 1 und/oder Radar-Signalgeneratoren 35 miteinander bzw. auf das (gemeinsame) Kalibriersignal 15 kalibriert bzw. hiermit synchronisiert werden können.

Besonders bevorzugt weisen die Steuereinrichtungen 20 der jeweiligen Referenzoszillatoranordnungen 1 bzw. Radarmodule 44 jeweils eine Zeitbasis 20A, insbesondere Uhr, auf, die weiter besonders bevorzugt miteinander oder jeweils mit demselben Kalibriersignal 15, 19 synchronisiert oder synchronisierbar sind. Mittels der jeweiligen Zeitbasis 20A können zeitlich synchronisierte Radarsignale 36 erzeugt werden. Hierzu kann die jeweilige Steuereinrichtung 20 das jeweilige Radarmodul 44 bzw. dessen Teiler 28 zur Erzeugung miteinander synchronisierter Radarsignale 36 steuern (triggern). Insbesondere erfolgt dies derart, dass zeitgleiche Frequenzrampen erzeugt werden.

Mittels der Taktsynchronisationseinrichtung 46 können entsprechend die Referenzoszillatoren 2, 4 bzw. die durch die Referenzoszillatoren 2, 4 erzeugbaren Taktsignale 29 der Referenzoszillatoranordnungen 1 bzw. Radarmodule 44, insbesondere also die zweiten Ausgangssignale 5 dieser, miteinander synchronisiert werden. Hierdurch können miteinander synchronisierte zweite Ausgangssignale 5 bereitgestellt werden.

Insbesondere sind die synchronisierten zweiten Ausgangssignale 5 frequenzsynchron und/oder phasensynchron. Entsprechend können die jeweiligen Radarmodule 44 frequenz- und oder phasensynchrone Taktsignale 29 erzeugen, mit denen entsprechend synchronisierte Radarsignale 36 durch die jeweiligen, bevorzugt ihrerseits miteinander synchronisierten bzw. synchronisierbaren, Radarmodule 44 bzw. durch deren, bevorzugt ihrerseits miteinander synchronisierten bzw. synchronisierbaren, Radar-Signalgeneratoren 35 erzeugt werden können.

Insbesondere können durch die jeweiligen Radarmodule 44 bzw. durch deren Referenzoszillatoranordnungen 1 jeweils zueinander gleiche bzw. synchrone Radarsignale 40 wie FMCW-Radarsignale, insbesondere Frequenzrampen bzw. FMCW-Rampen, erzeugt werden. Dies ermöglicht es in vorteilhafter Weise, ein Empfangssignal 34 zu verarbeiten, zu dekodieren und/oder zu analysieren und hierbei einen Informationsgehalt des Empfangssignals 36 zu extrahieren, auch wenn das Sendesignal 40, auf dem das Empfangssignal 34 basiert, nicht vom selben Radarmodul 44 stammt.

Im Darstellungsbeispiel gemäß Fig. 5 sind mehrere Radarmodule 44, insbesondere ein erstes Radarmodul 44A, ein zweites Radarmodul 44B, ein drittes Radarmodul 44C, ein viertes Radarmodul 44D und ein fünftes Radarmodul 44E, vorgesehen. Im Darstellungsbeispiel sendet lediglich das zweite Radarmodul 44B ein von diesem generiertes Radarsignal 36 über eine Antenne 41B des zweiten Radarmoduls 44B als Sendesignal 40.

Das Sendesignal 40 wird zum Reflexionssignal 47 durch Reflexionen an einem Objekt 48. Das Reflexionssignal 47 bildet bei Empfang durch eines der Radarmodule 44 bzw. eine Antenne 41A des ersten Radarmoduls 44, eine Antenne 41B des zweiten Radarmoduls 44B, eine Antenne 41C des dritten Radarmoduls 44C, eine Antenne 41D des Radarmoduls 44D und/oder eine Antenne 41E des fünften Radarmoduls 44E das jeweilige Empfangssignal 34A bis 34E.

Die Empfangssignale 34A bis 34E unterscheiden sich voneinander aufgrund der bevorzugt unterschiedlichen Position bzw. Lage bzw. Ausrichtung der jeweiligen Radarmodule 44A bis 44E. Die jeweiligen Radarmodule 44A bis 44E befinden sich also vorzugsweisen an unterschiedlichen Orten oder sind hierzu ausgebildet und eingerichtet. Jedenfalls wenn das Objekt 48 das Sendesignal 40 im Raum nicht gleichmäßig reflektiert, resultieren entsprechend voneinander abweichende Empfangssignale 34A bis 34E, wodurch zusätzliche Informationen über das Objekt 48 ermittelt werden können. Hierzu können die jeweiligen Empfangssignale 34A bis 34E einzeln oder gemeinsam über eine Signalverarbeitungseinrichtung 49 des Radarsystems 45 ausgewertet, insbesondere verglichen werden.

Im Darstellungsbeispiel gemäß Fig. 5 sind die jeweiligen Radarmodule 44 miteinander synchronisierbar bzw. synchronisiert, insbesondere deren Referenzoszillatoranordnungen 1 sind in der beschriebenen Art und Weise miteinander synchronisierbar bzw. synchronisiert, sodass die Empfangssignale 34A bis 34E jeweils ausgewertet und insbesondere durch Vergleich ergänzende Informationen aufgrund der räumlichen Verteilung der einzelnen Radarmodule 44 ermittelt werden können, auch wenn lediglich eines oder eine echte Teilmenge der insgesamt vorhandenen bzw. im Radarsystem 45 vorgesehenen Radarmodule 44 ein bzw. mehrere Sendesignal(e) 40 transmittieren.

Die Radarmodule 44 bzw. mehrere Referenzoszillatoranordnungen 1 können über Satellitennavigations-Signale 17 oder alternativ oder zusätzlich über eine Netzwerkschnittstelle, beispielsweise über ein Systemzeit-Synchronisationsprotokoll wie IEEE1588 synchronisiert werden. Alternativ oder zusätzlich kann das Kalibriersignal 15 über synchrone Ethernet-Systeme (SyncE) an die Referenzoszillatoranordnungen 1 bzw. Radarmodule 44 verteilt werden.

Es kann auch vorgesehen sein, dass die Radarmodule 44 im Wechsel bzw. nacheinander jeweils ein bzw. das (synchronisierte) Sendesignal 40 transmittieren und jeweils bevorzugt mehrere oder alle Radarmodule 44 ihre Empfangssignale 34A bis 34E, also das an der jeweiligen Position des jeweiligen Radarmoduls 44 empfangene Reflexionssignal 47, verarbeiten und auswerten (können).

In einem vorschlagsgemäßen Verfahren bzw. einer vorschlagsgemäßen Verwendung kann entsprechend vorgesehen sein, dass mehrere Referenzoszillatoren 2, 4 miteinander synchronisiert werden, wobei der erste der Referenzoszillatoren 2 im Freilauf eine bessere Frequenzgenauigkeit bzw. Referenzstabilität als der zweite Referenzoszillator 4 aufweist und der zweite Referenzoszillator 4 im Freilauf ein geringeres Phasenrauschen als der erste Referenzoszillator 2 aufweist und wobei die Frequenz des zweiten Referenzoszillators 4, insbesondere mit einem Phasenregelkreis 6, auf die Frequenz des ersten Referenzoszillators 2 geregelt wird und die Frequenz des ersten Referenzoszillators auf Basis eines Kalibriersignals 15 kalibriert wird.

Besonders bei Radarsystemen 45, insbesondere FMCW-Radarsystemen, bietet die vorschlagsgemäße Referenzoszillatoranordnung 1 aufgrund des durch sie zur Verfügung gestellten zweiten Ausgangssignals 5 mit verbesserten Eigenschaften bezüglich der Stabilität und Genauigkeit die Möglichkeit, die Messgenauigkeit des Radarsystems 45 bzw. Radarmoduls 44 mit einer solchen Referenzoszillatoranordnung 1 erheblich zu verbessern. Insbesondere wird die Messgenauigkeit bei Verwendung der vorschlagsgemäßen Referenzoszillatoranordnung 1 zur Entfernungsmessung oder Füllstandsmessung erheblich verbessert, sodass Abstände, Geschwindigkeiten, etc. genauer und sicherer ermittelt werden können.

Gleichzeitig wird der Einsatz von Ofenquarzoszillatoren vorzugsweise vermieden.

Diese bieten zwar eine gute Präzision und Stabilität, jedoch auf Kosten eines hohen Stromverbrauchs und einer verhältnismäßigen langen Aufheizphase, in der die nach Aufheizen erreichte Präzision und Stabilität noch nicht vorliegt. Die vorschlagsgemäße Referenzoszillatoranordnung 1 bietet das zweite Ausgangssignal 5 mit einer Frequenzstabilität und einem Phasenrauschen, die denen eines Ofenquarzoszillators ähneln, jedoch ohne die hiermit einhergehenden Nachteile einschließlich des hohen Produktionsaufwands für Ofenquarzoszillatoren, weshalb letztere in der Regel Spezialanwendungen vorbehalten bleiben.

Durch die vorschlagsgemäße Referenzoszillatoranordnung 1 wird also eine Referenzsignal- bzw. Taktquelle bereitgestellt, die aufgrund ihrer Präzision, Frequenzstabilität und des ressourcenschonenden Herstellungsprozesses im Vergleich zu Ofenquarzoszillatoren - trotz des Einsatzes von bevorzugt zwei Schwingquarzen - eine erhebliche Verbesserung auch von Einrichtungen mit großen Stückzahlen ermöglicht.

### Bezugszeichenliste:

- 1: Referenzoszillatoranordnung
- 2: Erster Referenzoszillator
- 3: Erstes Ausgangssignal (erster Referenzoszillator)
- 4: Zweiter Referenzoszillator
- 5: Zweites Ausgangssignal (zweiter Referenzoszillator)
- 6: Phasenregelkreis
- 7: Rückkopplung
- 8: Phasen-Frequenz-Detektor
- 9: Rückkoppeleingang
- 10: Referenzeingang
- 11: PFD-Ausgangssignal
- 12: Schleifenfilter
- 13: Steuergröße
- 14: Kalibriereingang
- 15: Kalibriersignal
- 16: Kalibriersignalquelle
- 17: Satellitennavigations-Signal
- 18: Multiplexer
- 19: Weiteres Kalibriersignal / Zeitsynchronisationssignal
- 20: Steuereinrichtung
- 20A: Zeitbasis
- 21: Auswahlsignal
- 22: Abstimmsignal
- 23: Frequenzsteuereinrichtung
- 24: Phasenunterschied
- 25: Takteinrichtung
- 26: Resetsignal
- 27: Reseteingang
- 28: Teiler
- 29: Taktsignal
- 30: Takteingang
- 31: Transceiver
- 32: Radarvorrichtung
- 33: Radarempfänger
- 34: Empfangssignal
- 35: Radar-Signalgenerator
- 36: Radarsignal
- 37: Mischer
- 38: IF-Signal
- 39: Radarsender
- 40: Sendesignal
- 41: Antenne
- 42: Kontrollsignal
- 43: Kontrolleingang
- 44: Radarmodul
- 45: Radarsystem
- 46: Taktsynchronisationseinrichtung
- 47: Reflexionssignal
- 48: Objekt
- 49: Signalverarbeitungseinrichtung
- FB: Filter-Bandbreite
- f(5): Frequenz des zweiten Ausgangssignals
- f(3): Frequenz des ersten Ausgangssignals
- P₀: Ausgangsleistung (Träger)
- P(3)_{dB}: spektrale Leistungsdichte des ersten Ausgangssignals
- P(5)_{dB}: spektrale Leistungsdichte des zweiten Ausgangssignals
- P_{N,5}: Phasenrauschenniveau des zweiten Referenzoszillators
- P_{N,3}: Phasenrauschenniveau des ersten Referenzoszillators
- t: Zeit
- U₃: Spannung des ersten Ausgangssignals
- U₁₃: Spannung der Steuergröße
- U₁₅: Spannung des Kalibriersignals
- U₂₁: Spannung des Auswahlsignals
- U₂₂: Spannung des Abstimmsignals

## Patentansprüche

1. Radarsystem (45) mit mehreren Referenzoszillatoranordnungen (1), von denen mindestens eine Referenzoszillatoranordnung (1) einen ersten Referenzoszillator (2) zur Erzeugung eines ersten Ausgangssignals (3) und einen zweiten Referenzoszillator (4) zur Erzeugung eines zweiten Ausgangssignals (5) aufweist,
wobei die mindestens eine Referenzoszillatoranordnung (1) einen Phasenregelkreis (6) zur Regelung der Frequenz des zweiten Referenzoszillators (4) auf die Frequenz des ersten Referenzoszillators (2) und/oder zur Regelung der Phase des zweiten Referenzoszillators (4) auf die Phase des ersten Referenzoszillators (2) aufweist, wobei der erste Referenzoszillator (2) im Freilauf eine bessere Frequenzstabilität als der zweite Referenzoszillator (4) aufweist und der zweite Referenzoszillator (4) im Freilauf ein geringeres Phasenrauschen als der erste Referenzoszillator (2) aufweist,
wobei das Radarsystem (45) eine Taktsynchronisationseinrichtung (46) zur Synchronisation von durch die Referenzoszillatoranordnungen (1) erzeugbare Taktsignale (29) der Referenzoszillatoranordnungen (1) aufweist, sodass die Referenzoszillatoranordnungen (1) miteinander synchronisierte Ausgangssignale (5) bereitstellen, insbesondere frequenzsynchrone und/oder phasensynchrone Ausgangssignale (5), und
wobei das von der mindestens einen Referenzoszillatoranordnung (1) erzeugbare Taktsignal (29) dem zweiten Ausgangssignal (5) entspricht oder hiervon abgeleitet ist.

2. Radarsystem nach Anspruch 1, **dadurch gekennzeichnet, dass** das Radarsystem (45) dazu ausgebildet ist, mit den Ausgangssignalen (5) jeweils Radarsignale (36), vorzugsweise FMCW-Rampen, synchron zueinander zu erzeugen.

3. Radarsystem nach Anspruch 1 oder 2, **dadurch gekennzeichnet, dass** das Radarsystem (45) mehrere Radarempfänger (33) aufweist, die jeweils mit einem der synchronisierten Ausgangssignale (5) betrieben werden, sodass ein von dem jeweiligen Radarempfänger (33) empfangenes oder empfangbares Empfangssignal (34) mit dem jeweiligen der synchronisierten Ausgangssignale (5) durch den jeweiligen Radarempfänger (33) verarbeitbar sind oder verarbeitet werden.

4. Radarsystem nach Anspruch 3, **dadurch gekennzeichnet, dass** das Radarsystem (45) einen Radarsender (39) zur Emission eines Radarsignals (36) aufweist, das auf Basis eines der Ausgangssignale (5) erzeugbar ist.

5. Radarsystem nach Anspruch 4, **dadurch gekennzeichnet, dass** mindestens einer der Radarempfänger (33) an einer von einer Position des Radarsenders (39) abweichenden Position angeordnet oder anordenbar ist und ein Reflexionssignal (47) des durch den Radarsender (39) emittierten Radarsignals (36) als Empfangssignal (34) durch den Radarempfänger (33) empfangbar ist.

6. Radarsystem nach einem der voranstehenden Ansprüche, **dadurch gekennzeichnet, dass** von der mindestens einen Referenzoszillatoranordnung (1) die Frequenz und/oder Phase zumindest des zweiten Referenzoszillators (4) abstimmbar ist und der Phasenregelkreis (6) zur Regelung der Frequenz des zweiten Referenzoszillators (4) auf die Frequenz des ersten Referenzoszillators (2) und/oder zur Regelung der Phase des zweiten Referenzoszillators (4) auf die Phase des ersten Referenzoszillators (2) ausgebildet ist.

7. Radarsystem nach einem der voranstehenden Ansprüche, **dadurch gekennzeichnet, dass** die mindestens eine Referenzoszillatoranordnung (1) einen Steuereingang für ein externes Kalibriersignal (15) aufweist und dazu ausgebildet ist, die Frequenz und/oder Phase des ersten Referenzoszillators (2) an das externe Kalibriersignal (15) anzugleichen.

8. Radarsystem nach Anspruch 7, **dadurch gekennzeichnet, dass** die mindestens eine Referenzoszillatoranordnung (1) eine Steuereinrichtung (20) zur Kalibrierung des ersten Referenzoszillators (2) zur Verringerung oder Kompensation eines Frequenzunterschieds zwischen einer Frequenz des ersten Ausgangssignals (3) des ersten Referenzoszillators (3) und dem externen Kalibriersignal (15) und/oder zur Verringerung oder Kompensation eines Phasenunterschieds zwischen einer Phase des ersten Ausgangssignals (3) des ersten Referenzoszillators (3) und dem externen Kalibriersignal (15) aufweist, vorzugsweise wobei
der erste Referenzoszillator (2) zur Verringerung oder Kompensation eines Frequenzunterschieds zwischen einer Frequenz des ersten Ausgangssignals (3) des ersten Referenzoszillators (3) und dem externen Kalibriersignal (15) und/oder zur Verringerung oder Kompensation eines Phasenunterschieds zwischen einer Phase des ersten Ausgangssignals (3) des ersten Referenzoszillators (3) und dem externen Kalibriersignal (15) abstimmbar ist.

9. Radarsystem nach Anspruch 8, **dadurch gekennzeichnet, dass** die Steuereinrichtung (20) dazu ausgebildet ist, das Kalibriersignal (15) mit dem Phasenregelkreis (6) zu koppeln, sodass der Phasenregelkreis (6) den zweiten Referenzoszillator (4) mit dem Kalibriersignal (15) synchronisiert.

10. Radarsystem nach einem der Ansprüche 7 bis 9, **dadurch gekennzeichnet, dass** der erste Referenzoszillator (2) mit einem Kalibriersignal (15) als Referenzsignal bzw. externem Frequenznormal phasenweise synchronisierbar ist, vorzugsweise wobei der erste Referenzoszillator (2) in einer ersten Phase eines Intervalls synchronisiert wird, während er in einer zweiten Phase des Intervalls frei läuft, insbesondere sodass der erste Referenzoszillator (2) bzw. das Radarsystem (45) mit dem Kalibriersignal (15) wiederholt kalibriert wird.

11. Radarsystem nach einem der Ansprüche 8 bis 10, **dadurch gekennzeichnet, dass** die Steuereinrichtung (20) dazu ausgebildet ist, Frequenzen und/oder Phasen des externen Kalibriersignals (15) und des Ausgangssignals (3) des ersten Referenzoszillators (2) oder von hierzu korrespondierenden Werten oder Parametern zu ermitteln, und, vorzugsweise,
durch Kalibrierung des ersten Referenzoszillators (2) einen Unterschied einer Steuergröße (13) des Phasenregelkreises (6) bei mit dem Phasenregelkreis (6) gekoppeltem Kalibriersignal (15) im Vergleich zu der Steuergröße (13) bei mit dem Phasenregelkreis (6) gekoppeltem ersten Referenzoszillator (2) zu minimieren.

12. Radarsystem nach einem der voranstehenden Ansprüche, **dadurch gekennzeichnet, dass** der zweite Referenzoszillator (4) mit einer Takteinrichtung (25) zur Bereitstellung eines von dem zweiten Ausgangssignal (5) des zweiten Referenzoszillators (4) abgeleiteten Taktsignals (29) gekoppelt ist,
vorzugsweise wobei über die Takteinrichtung (25) auf Basis des zweiten Ausgangssignals (5) des zweiten Referenzoszillators (4) ein oder mehrere Taktsignale (29) durch Teilung des Ausgangssignals (5) des zweiten Referenzoszillators (4) erzeugbar ist/sind.

13. Synchronisationsverfahren für Radarsysteme (45),
wobei mehrere Referenzoszillatoranordnungen (1) zur Synchronisation von durch die Referenzoszillatoranordnungen (1) erzeugbare Taktsignale (29) miteinander synchronisiert werden, von denen mindestens eine Referenzoszillatoranordnung (1) einen ersten Referenzoszillator (2) und einen zweiten Referenzoszillator (4) aufweist, wobei der erste Referenzoszillator (2) im Freilauf eine bessere Frequenzstabilität als der zweite Referenzoszillator (4) aufweist und der zweite Referenzoszillator (4) im Freilauf ein geringeres Phasenrauschen als der erste Referenzoszillator (2) aufweist,
wobei die Frequenz des zweiten Referenzoszillators (4) mit einem Phasenregelkreis (6) auf die Frequenz des ersten Referenzoszillators (2) geregelt wird und/oder wobei die Phase des zweiten Referenzoszillators (4) mit einem Phasenregelkreis (6) auf die Phase des ersten Referenzoszillators (2) geregelt wird,
wobei die Frequenz und/oder Phase des ersten Referenzoszillators (2) auf Basis eines Kalibriersignals (15), bevorzugt mittels Synchronisation des zweiten Referenzoszillators (4) mit dem Kalibriersignal (15), kalibriert wird,
wobei die Referenzoszillatoranordnungen (1) miteinander synchronisierte Ausgangssignale (5) bereitstellen, insbesondere frequenzsynchrone und/oder phasensynchrone Ausgangssignale (5), und
wobei das von der mindestens einen Referenzoszillatoranordnung (1) erzeugbare Taktsignal (29) dem zweiten Ausgangssignal (5) entspricht oder hiervon abgeleitet ist.

14. Synchronisationsverfahren nach Anspruch 13, **dadurch gekennzeichnet,**
**dass** der erste Referenzoszillator (2) im Freilauf eine bessere Frequenzgenauigkeit als der zweite Referenzoszillator (4) und/oder
**dass** der zweite Referenzoszillator (4) im Freilauf ein geringeres Phasenrauschen als der erste Referenzoszillator (2) aufweist; und/oder
**dass** der erste Referenzoszillator (2) mit einem Kalibriersignal (15) als Referenzsignal bzw. externem Frequenznormal nur phasenweise synchronisiert wird, vorzugsweise wobei der erste Referenzoszillator (2) in einer ersten Phase eines Intervalls synchronisiert wird, während er in einer zweiten Phase des Intervalls frei läuft, insbesondere sodass der erste Referenzoszillator (2) bzw. das Radarsystem (45) mit dem Kalibriersignal (15) wiederholt kalibriert wird.

## Claims

1. Radar system (45) having a plurality of reference oscillator arrangements (1), of which at least one reference oscillator arrangement (1) comprises a first reference oscillator (2) for generating a first output signal (3) and a second reference oscillator (4) for generating a second output signal (5),
wherein the at least one reference oscillator arrangement (1) comprises a phase-locked loop (6) for feedback controlling the frequency of the second reference oscillator (4) to the frequency of the first reference oscillator (2) and/or for feedback controlling the phase of the second reference oscillator (4) to the phase of the first reference oscillator (2), wherein the first reference oscillator (2) has a better frequency stability in free-running than the second reference oscillator (4) and the second reference oscillator (4) has a lower phase noise in free-running than the first reference oscillator (2),
wherein the radar system (45) comprises a clock synchronization device (46) for synchronizing clock signals (29) of the reference oscillator arrangements (1) that are generatable by the reference oscillator arrangements (1), so that the reference oscillator arrangements (1) provide mutually synchronized output signals (5), in particular frequency-synchronous and/or phase-synchronous output signals (5), and
wherein the clock signal (29) which are generatable by the at least one reference oscillator arrangement (1) corresponds to the second output signal (5) or is derived therefrom.

2. Radar system according to claim 1, **characterized in that** the radar system (45) is configured to generate radar signals (36), preferably FMCW ramps, synchronously with one another with the output signals (5), respectively.

3. Radar system according to claim 1 or 2, **characterized in that** the radar system (45) comprises a plurality of radar receivers (33), each of which is operated with one of the synchronized output signals (5), so that a receive signal (34) received or receivable by the respective radar receiver (33) is processable or processed with the respective one of the synchronized output signals (5) by the respective radar receiver (33).

4. Radar system according to claim 3, **characterized in that** the radar system (45) comprises a radar transmitter (39) for emitting a radar signal (36) generatable on the basis of one of the output signals (5).

5. Radar system according to claim 4, **characterized in that** at least one of the radar receivers (33) is arranged or arrangeable at a position differing from a position of the radar transmitter (39) and a reflection signal (47) of the radar signal (36) emitted by the radar transmitter (39) is receivable as a receive signal (34) by the radar receiver (33).

6. Radar system according to one of the preceding claims, **characterized in that** the frequency and/or phase of at least the second reference oscillator (4) is tuneable by the at least one reference oscillator arrangement (1) and the phase-locked loop (6) is configured for feedback controlling the frequency of the second reference oscillator (4) to the frequency of the first reference oscillator (2) and/or for feedback controlling the phase of the second reference oscillator (4) to the phase of the first reference oscillator (2).

7. Radar system according to one of the preceding claims, **characterized in that** the at least one reference oscillator arrangement (1) has a control input for an external calibration signal (15) and is configured to match the frequency and/or phase of the first reference oscillator (2) to the external calibration signal (15).

8. Radar system according to claim 7, **characterized in that** the at least one reference oscillator arrangement (1) comprises a control device (20) for calibrating the first reference oscillator (2) for reducing or compensating a frequency difference between a frequency of the first output signal (3) of the first reference oscillator (3) and the external calibration signal (15) and/or for reducing or compensating a phase difference between a phase of the first output signal (3) of the first reference oscillator (3) and the external calibration signal (15), preferably wherein
the first reference oscillator (2) is tuneable for reducing or compensating a frequency difference between a frequency of the first output signal (3) of the first reference oscillator (3) and the external calibration signal (15) and/or for reducing or compensating a phase difference between a phase of the first output signal (3) of the first reference oscillator (3) and the external calibration signal (15).

9. Radar system according to claim 8, **characterized in that** the control device (20) is configured to couple the calibration signal (15) to the phase-locked loop (6) so that the phase-locked loop (6) synchronizes the second reference oscillator (4) with the calibration signal (15).

10. Radar system according to one of claims 7 to 9, **characterized in that** the first reference oscillator (2) is intermittently synchronizable with a calibration signal (15) as a reference signal and/or external frequency standard, preferably wherein the first reference oscillator (2) is synchronized in a first phase of an interval, while it runs freely in a second phase of the interval, in particular so that the first reference oscillator (2) and/or the radar system (45) is repeatedly calibrated with the calibration signal (15).

11. Radar system according to one of claims 8 to 10, **characterized in that** the control device (20) is configured to determine frequencies and/or phases of the external calibration signal (15) and of the output signal (3) of the first reference oscillator (2) or of values or parameters corresponding thereto, and preferably
to minimize, by calibration of the first reference oscillator (2), a difference in a control variable (13) of the phase-locked loop (6) when the calibration signal (15) is coupled to the phase-locked loop (6) compared with the control variable (13) when the first reference oscillator (2) is coupled to the phase-locked loop (6).

12. Radar system according to one of the preceding claims, **characterized in that** the second reference oscillator (4) is coupled to a clock device (25) for providing a clock signal (29) derived from the second output signal (5) of the second reference oscillator (4),
preferably wherein one or more clock signals (29) is/are generatable via the clock device (25) on the basis of the second output signal (5) of the second reference oscillator (4) by dividing the output signal (5) of the second reference oscillator (4).

13. Synchronization method for radar systems (45),
wherein a plurality of reference oscillator arrangements (1) are synchronized with one another for synchronizing clock signals (29) generatable by the reference oscillator arrangements (1), of which at least one reference oscillator arrangement (1) comprises a first reference oscillator (2) and a second reference oscillator (4), wherein the first reference oscillator (2) has a better frequency stability in free-running than the second reference oscillator (4) and the second reference oscillator (4) has a lower phase noise in free-running than the first reference oscillator (2),
wherein the frequency of the second reference oscillator (4) is feedback controlled to the frequency of the first reference oscillator (2) by a phase-locked loop (6) and/or wherein the phase of the second reference oscillator (4) is feedback controlled to the phase of the first reference oscillator (2) by a phase-locked loop (6),
wherein the frequency and/or phase of the first reference oscillator (2) is calibrated on the basis of a calibration signal (15), preferably by means of synchronization of the second reference oscillator (4) with the calibration signal (15),
wherein the reference oscillator arrangements (1) provide mutually synchronized output signals (5), in particular frequency-synchronous and/or phase-synchronous output signals (5), and
wherein the clock signal (29) generatable by the at least one reference oscillator arrangement (1) corresponds to the second output signal (5) or is derived therefrom.

14. Synchronization method according to claim 13, **characterized in that**
the first reference oscillator (2) has a better frequency accuracy in free-running than the second reference oscillator (4) and/or
the second reference oscillator (4) has a lower phase noise in free-running than the first reference oscillator (2); and/or
the first reference oscillator (2) is only intermittently synchronized with a calibration signal (15) as a reference signal and/or external frequency standard, preferably wherein the first reference oscillator (2) is synchronized in a first phase of an interval, while it runs freely in a second phase of the interval, in particular so that the first reference oscillator (2) and/or the radar system (45) is repeatedly calibrated with the calibration signal (15).

## Revendications

1. Système radar (45) comprenant plusieurs dispositifs oscillateurs de référence (1), parmi lesquels au moins un dispositif oscillateur de référence (1) présente un premier oscillateur de référence (2) pour générer un premier signal de sortie (3) et un deuxième oscillateur de référence (4) pour générer un deuxième signal de sortie (5),
dans lequel l'au moins un dispositif oscillateur de référence (1) présente une boucle à verrouillage de phase (6) pour asservir la fréquence du deuxième oscillateur de référence (4) à la fréquence du premier oscillateur de référence (2) et/ou pour asservir la phase du deuxième oscillateur de référence (4) à la phase du premier oscillateur de référence (2), le premier oscillateur de référence (2) présentant en roue libre une meilleure stabilité de fréquence que le deuxième oscillateur de référence (4) et le deuxième oscillateur de référence (4) présentant en roue libre un bruit de phase plus faible que le premier oscillateur de référence (2),
dans lequel le système radar (45) présente un dispositif de synchronisation d'horloge (46) pour synchroniser des signaux d'horloge (29) des dispositifs oscillateurs de référence (1) pouvant être générés par les dispositifs oscillateurs de référence (1), de sorte que les dispositifs oscillateurs de référence (1) fournissent des signaux de sortie (5) synchronisés les uns avec les autres, en particulier des signaux de sortie (5) synchrones en fréquence et/ou synchrones en phase, et
dans lequel le signal d'horloge (29) pouvant être généré par l'au moins un dispositif oscillateur de référence (1) correspond au deuxième signal de sortie (5) ou est dérivé de celui-ci.

2. Système radar selon la revendication 1, **caractérisé en ce que** le système radar (45) est réalisé pour générer avec les signaux de sortie (5) respectivement des signaux radar (36), de préférence des rampes FMCW, de manière synchrone les uns par rapport aux autres.

3. Système radar selon la revendication 1 ou 2, **caractérisé en ce que** le système radar (45) présente plusieurs récepteurs radar (33) qui fonctionnent respectivement avec l'un des signaux de sortie (5) synchronisés, de sorte qu'un signal de réception (34) reçu ou pouvant être reçu par le récepteur radar (33) respectif peut être traité ou est traité avec le signal de sortie (5) synchronisé respectif par le récepteur radar (33) respectif.

4. Système radar selon la revendication 3, **caractérisé en ce que** le système radar (45) présente un émetteur radar (39) pour émettre un signal radar (36) qui peut être généré sur la base de l'un des signaux de sortie (5).

5. Système radar selon la revendication 4, **caractérisé en ce qu'**au moins l'un des récepteurs radar (33) est disposé ou peut être disposé à une position différente d'une position de l'émetteur radar (39) et un signal de réflexion (47) du signal radar (36) émis par l'émetteur radar (39) peut être reçu en tant que signal de réception (34) par le récepteur radar (33).

6. Système radar selon l'une quelconque des revendications précédentes, **caractérisé en ce que** l'au moins un dispositif oscillateur de référence (1) peut accorder la fréquence et/ou la phase d'au moins le deuxième oscillateur de référence (4) et la boucle à verrouillage de phase (6) est conçue pour asservir la fréquence du deuxième oscillateur de référence (4) à la fréquence du premier oscillateur de référence (2) et/ou pour asservir la phase du deuxième oscillateur de référence (4) à la phase du premier oscillateur de référence (2).

7. Système radar selon l'une quelconque des revendications précédentes, **caractérisé en ce que** l'au moins un dispositif oscillateur de référence (1) présente une entrée de commande pour un signal de calibrage externe (15) et est conçu pour adapter la fréquence et/ou la phase du premier oscillateur de référence (2) au signal de calibrage externe (15).

8. Système radar selon la revendication 7, **caractérisé en ce que** l'au moins un dispositif oscillateur de référence (1) présente un dispositif de commande (20) pour calibrer le premier oscillateur de référence (2) pour réduire ou compenser une différence de fréquence entre une fréquence du premier signal de sortie (3) du premier oscillateur de référence (3) et le signal de calibrage externe (15) et/ou pour réduire ou compenser une différence de phase entre une phase du premier signal de sortie (3) du premier oscillateur de référence (3) et le signal de calibrage externe (15), de préférence, le premier oscillateur de référence (2) pouvant être accordé pour réduire ou compenser une différence de fréquence entre une fréquence du premier signal de sortie (3) du premier oscillateur de référence (3) et le signal de calibrage externe (15) et/ou pour réduire ou compenser une différence de phase entre une phase du premier signal de sortie (3) du premier oscillateur de référence (3) et le signal de calibrage externe (15).

9. Système radar selon la revendication 8, **caractérisé en ce que** le dispositif de commande (20) est conçu pour coupler le signal de calibrage (15) à la boucle à verrouillage de phase (6), de sorte que la boucle à verrouillage de phase (6) synchronise le deuxième oscillateur de référence (4) avec le signal de calibrage (15).

10. Système radar selon l'une quelconque des revendications 7 à 9, **caractérisé en ce que** le premier oscillateur de référence (2) peut être synchronisé de façon intermittente avec un signal de calibrage (15) en tant que signal de référence et/ou étalon de fréquence externe, de préférence le premier oscillateur de référence (2) étant synchronisé dans une première phase d'un intervalle, alors qu'il fonctionne librement dans une deuxième phase de l'intervalle, en particulier de sorte que le premier oscillateur de référence (2) et/ou le système radar (45) sont calibrés de manière répétée avec le signal de calibrage (15).

11. Système radar selon l'une quelconque des revendications 8 à 10, **caractérisé en ce que** le dispositif de commande (20) est conçu pour déterminer des fréquences et/ou des phases du signal de calibrage externe (15) et du signal de sortie (3) du premier oscillateur de référence (2) ou de valeurs ou paramètres correspondant à ceux-ci, et, de préférence,
par calibrage du premier oscillateur de référence (2), minimiser une différence d'une grandeur de commande (13) de la boucle à verrouillage de phase (6) lorsque le signal de calibrage (15) est couplé à la boucle à verrouillage de phase (6) par rapport à la grandeur de commande (13) lorsque le premier oscillateur de référence (2) est couplé à la boucle à verrouillage de phase (6).

12. Système radar selon l'une quelconque des revendications précédentes, **caractérisé en ce que** le deuxième oscillateur de référence (4) est couplé à un dispositif d'horloge (25) pour fournir un signal d'horloge (29) dérivé du deuxième signal de sortie (5) du deuxième oscillateur de référence (4),
de préférence dans lequel un ou plusieurs signaux d'horloge (29) peuvent être générés par division du signal de sortie (5) du deuxième oscillateur de référence (4) par le biais du dispositif d'horloge (25) sur la base du deuxième signal de sortie (5) du deuxième oscillateur de référence (4).

13. Procédé de synchronisation pour des systèmes radar (45),
dans lequel plusieurs dispositifs oscillateurs de référence (1) sont synchronisés les uns avec les autres pour synchroniser des signaux d'horloge (29) pouvant être générés par les dispositifs oscillateurs de référence (1), parmi lesquels au moins un dispositif oscillateur de référence (1) présente un premier oscillateur de référence (2) et un deuxième oscillateur de référence (4), le premier oscillateur de référence (2) présentant en roue libre une meilleure stabilité de fréquence que le deuxième oscillateur de référence (4) et le deuxième oscillateur de référence (4) présentant en roue libre un bruit de phase plus faible que le premier oscillateur de référence (2),
dans lequel la fréquence du deuxième oscillateur de référence (4) est asservie avec une boucle à verrouillage de phase (6) à la fréquence du premier oscillateur de référence (2) et/ou dans lequel la phase du deuxième oscillateur de référence (4) est asservie avec une boucle à verrouillage de phase (6) à la phase du premier oscillateur de référence (2),
dans lequel la fréquence et/ou la phase du premier oscillateur de référence (2) est calibrée sur la base d'un signal de calibrage (15), de préférence au moyen d'une synchronisation du deuxième oscillateur de référence (4) avec le signal de calibrage (15),
dans lequel les dispositifs oscillateurs de référence (1) fournissent des signaux de sortie (5) synchronisés les uns avec les autres, en particulier des signaux de sortie (5) synchrones en fréquence et/ou synchrones en phase, et
dans lequel le signal d'horloge (29) pouvant être généré par l'au moins un dispositif oscillateur de référence (1) correspond au deuxième signal de sortie (5) ou est dérivé de celui-ci.

14. Procédé de synchronisation selon la revendication 13, **caractérisé en ce que**
le premier oscillateur de référence (2) présente en roue libre une meilleure précision de fréquence que le deuxième oscillateur de référence (4) et/ou
le deuxième oscillateur de référence (4) présente en roue libre un bruit de phase plus faible que le premier oscillateur de référence (2) ; et/ou
le premier oscillateur de référence (2) n'est synchronisé de façon intermittente avec un signal de calibrage (15) en tant que signal de référence et/ou étalon de fréquence externe, de préférence le premier oscillateur de référence (2) étant synchronisé dans une première phase d'un intervalle, alors qu'il fonctionne librement dans une deuxième phase de l'intervalle, en particulier de sorte que le premier oscillateur de référence (2) et/ou le système radar (45) est calibré de manière répétée avec le signal de calibrage (15).
